# EUROPEAN PATENT APPLICATION

(11) **EP 2 592 587 A1**
(43) Date of publication of application: **15.05.2013**
(21) Application number: 12189097.4
(22) Date of filing: 18.10.2012
(51) Int. Cl.: G06Q 10/06, G06Q 10/10

(54) **Mobile terminal and method of operating the same**

(30) Priority: 18.10.2011 KR 20110106574
(71) Applicant: LG ELECTRONICS INC., Youngdungpo-gu Seoul 150-721 (KR)
(72) Inventor: Kim, Kwichun, Changwon-si 641-110 (KR)
(74) Representative: Vossius & Partner

(57) **Abstract**

Provided are a mobile terminal and a method of operating the same. The method includes: displaying a service request menu through a display unit; receiving a selection input of the service request menu; displaying a service request schedule input window through the display unit when the service request menu is selected and inputted; inputting a service request schedule through the service request schedule input window; and transmitting service request information, which includes the service request schedule inputted through the service request schedule input window, to another mobile terminal connected via a wireless communication network.

## Description

The present invention relates to a mobile terminal and a method of operating the same, and more particularly, to a mobile terminal and a method of operating the same, which process a service request from a user when an electronic device operates abnormally.

When an electronic device operates abnormally, a user requests an after sale service (AS) to a service center in order to receive the repairing service of the electronic device. In general, a user explains an abnormal symptom of an electronic device and asks about troubleshooting to an operator after a call is connected to a service center. If necessary, the user requests technician dispatch. Accordingly, the operator adjusts a technician dispatch schedule through consultation with the user, and then, notifies the confirmed schedule to the technician. By doing so, the technician who receives the notification, visits the user.

However, in such a service approach, a procedure that a user requests service is cumbersome, and especially, an operator is often busy with other calls. As a result, a service request is not immediately processed.

Especially, in the case of an air conditioner that operates in a high temperature environment, a user experiences great discomfort when the air conditioner broke down. Furthermore, in the case of an air conditioning system including a plurality of outdoor units and indoor units for conditioning air in a building having a plurality of inside spaces, discomfort due to service delay is enormous. Therefore, it is necessary to take measures for a user's easy and prompt service request and an immediate and seamless response to a user's service request.

Thus, an object of the present invention is to provide a mobile terminal and a method of operating the same, which immediately process user's inconvenience due to an abnormal operation of an electronic device.

According to an aspect of the present invention, there is provided a method of operating a mobile terminal, the method including: displaying a service request menu through a display unit; receiving a selection input of the service request menu; displaying a service request schedule input window through the display unit when the service request menu is selected and inputted; inputting a service request schedule through the service request schedule input window; and transmitting service request information, which includes the service request schedule inputted through the service request schedule input window, to another mobile terminal connected via a wireless communication network.

According to another aspect of the present invention, there is provided a mobile terminal including: a display unit displaying a service request menu; a wireless communication unit connected to be communicated with another mobile terminal connected to a wireless communication network; and a control unit controlling the display unit to display a service request schedule input window when the service request menu is selected, and controlling the wireless communication unit to transmit service request information, which includes a service request schedule inputted through the service request schedule input window, to another mobile terminal.

The accompanying drawings, which are included to provide a further understanding of the invention and are incorporated in and constitute a part of this specification, illustrate embodiments of the invention and together with the description serve to explain the principles of the invention.

In the drawings:
FIGS. 1 and 2 are views illustrating an electronic device service system from the view point of communication performed between mobile terminals of a user, a manager, and a technician according to an embodiment of the present invention;
FIG. 3 is a block diagram illustrating an electronic device service system according to an embodiment of the present invention;
FIG. 4 is a flowchart illustrating an operation for processing a service request through the electronic device service system of FIG. 3;
FIG. 5 is a block diagram illustrating main components of a mobile terminal according to an embodiment of the present invention;
FIG. 6 is a perspective view as seen from the front of a mobile terminal according to an embodiment of the present invention;
FIG. 7 is a perspective view as seen from the rear of a mobile terminal according to an embodiment of the present invention;
FIG. 8 is a block diagram illustrating important components of the management device of FIG. 3;
FIG. 9 is a screen view displayed through a display unit of a user mobile terminal according to an embodiment of the present invention;
FIG. 10 is screen views displayed when the service request menu is selected in FIG. 9;
FIGS. 11(a) to 11(f) are views of processes for inputting a schedule that a user wants to receive service through a service request schedule input window are sequentially shown;
Fig. 12 is a screen including a transmission completion display window for notifying that a service request schedule is normally transmitted via a wireless communication network through the processes described with reference to FIG. 11;
FIG. 13 is a view illustrating abnormal symptom and action information on an electronic device, which are displayed through the display play unit, when items of the abnormal symptom list 236 are selected;
FIG. 14 is a view illustrating screens displayed through the display unit of a user mobile terminal when the service request list display menu is selected from the main menu (especially, FIG. 14 is a view illustrating processes for inputting user satisfaction on service request completed items);
FIG. 15 is view illustrating a screen displayed through the display unit of the user mobile terminal when a user information input menu is selected from a main menu;
FIG. 16 is view illustrating a screen displayed through the display unit of the user mobile terminal when a warrantee information input menu is selected;
FIG. 17 is view illustrating a screen displayed through the display unit of the user mobile terminal when a private information protection policy display menu is selected;
FIG. 18 is a flowchart illustrating a method of operating a user mobile terminal according to an embodiment of the present invention;
FIG. 19 is a screen view displayed through a display unit of a manager mobile terminal according to an embodiment of the present invention;
FIG. 20 is a view of a service request information display screen is displayed when the first service request notification item is selected in FIG. 19;
FIGS. 21(a) to 21(d) are views when processes for inputting a technician dispatch schedule by the manager through the service dispatch schedule input window are sequentially illustrated;
FIG. 22 is a view of a screen including the service dispatch request list, which is displayed through the display unit of the manager mobile terminal;
FIG. 23 is view illustrating a screen displayed through the display unit of the manager mobile terminal when the first service request item FIG. 22 is selected;
FIG. 24 is a flowchart illustrating a method of operating a manager mobile terminal according to an embodiment of the present invention;
FIG. 25 is a screen view displayed through a display unit of a technician mobile terminal according to an embodiment of the present invention;
FIG. 26 is a view when the screen that a technician confirms a service display request through the screen displayed through the display unit of the technician mobile terminal when the service dispatch request item is selected is compared with the screen displayed when the technician rejects the service dispatch request; and
FIG. 27 is a flowchart illustrating a method of operating a technician mobile terminal according to an embodiment of the present invention.

The foregoing and other objects, features, aspects and advantages of the present invention will become more apparent from the following detailed description of the present invention when taken in conjunction with the accompanying drawings. Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions may be exaggerated for clarity, and the same reference numerals will be used throughout to designate the same or like components.

A mobile terminal described in this specification includes a mobile phone, a smart phone, a notebook computer, a digital broadcasting terminal, a Personal Digital Assistant (PDA), a Portable Multimedia Player (PMP), and a navigation system. Additionally, the suffixes "module" and "unit" for components used in description below are simply assigned just in consideration of easiness of specification writing, and thus, significant meanings or roles are not given by itself. Accordingly, "module' and "unit" may be interchangeably used.

Additionally, throughout the specification, a "user mobile terminal" refers to a mobile terminal with which a user requests service; a "manager mobile terminal" refers to a mobile terminal with which a manager requests service dispatch to a technician in response to a user's service request; and a "technician mobile terminal" refers to a mobile terminal that a technician uses, which receives a service dispatch request from a manager mobile terminal and is used for the response.

Moreover, throughout the specification, an electronic device is the collective concept of electrical and mechanical appliances equipped with a circuit based on electronic devices or components, and in more detail, includes electro-acoustic devices used in home (for example, a stereo system, a record player, an interphone, a TV, a radio etc.), cooking electric heaters using electric heat (for example, an electric rice cooker, an electric oven, a toaster, an electric cooker, etc.), heating appliances (for example, an electric stove, an electric blanket, an electric pad, etc.), lighting devices (for example, a fluorescent lamp, an incandescent lamp, a germicidal lamp, a mercury lamp, etc.), consumer electronics using a motor (for example, an electric vacuum cleaner, a washing machine, a fan, a ventilator, a dishwasher, etc.), and temperature control equipment for controlling a temperature of ambient air through a phase change of a circulating refrigerant (for example, an electric refrigerator, an air conditioner, etc.). Hereinafter, an air conditioner will be described as an example.

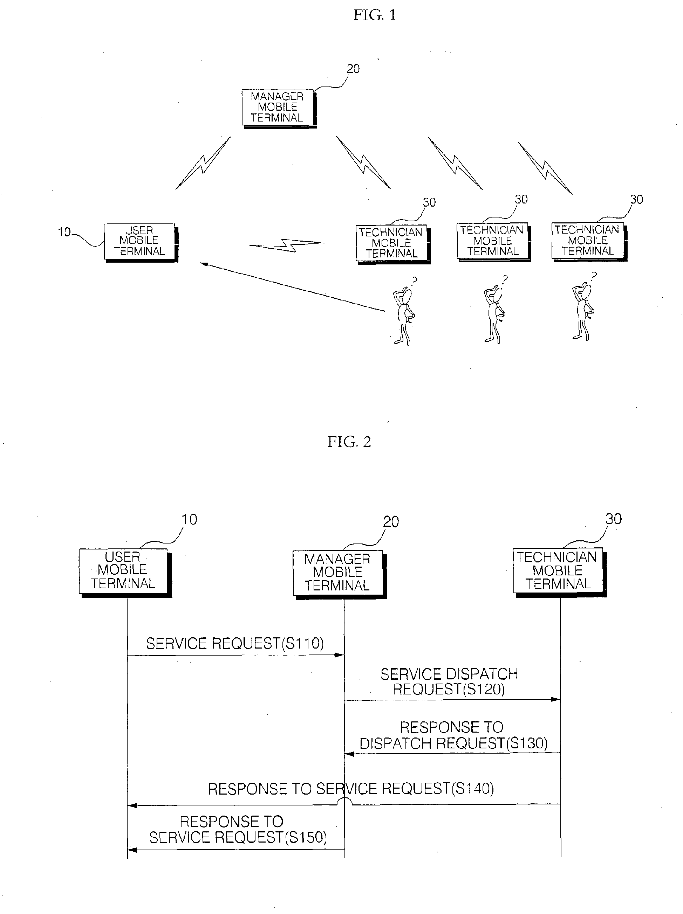

FIGS. 1 and 2 are views illustrating an electronic device service system from the point of view of communication performed between mobile terminals of a user, a manager, and a technician according to an embodiment of the present invention. Hereinafter, referring to FIGS. 1 and 2, an operation for processing a user's service request will be described according to an embodiment of the present invention.

A user mobile terminal 10, a manager mobile terminal 20, and a technician mobile terminal 30 are mutually communicated with each other through a wireless network connection. The wireless communication network may allow wireless communication between the user mobile terminal 10, the manager mobile terminal 20, and the technician mobile terminal 30, and may use a wireless communication technique such as commercial mobile communication service provided by a mobile communication service provider, Wireless LAN (WLAN), Wi-Fi, Wireless broadband(Wibro), World Interoperability for Microwave Access (Wimax), and High Speed Downlink Packet Access (HSDPA).

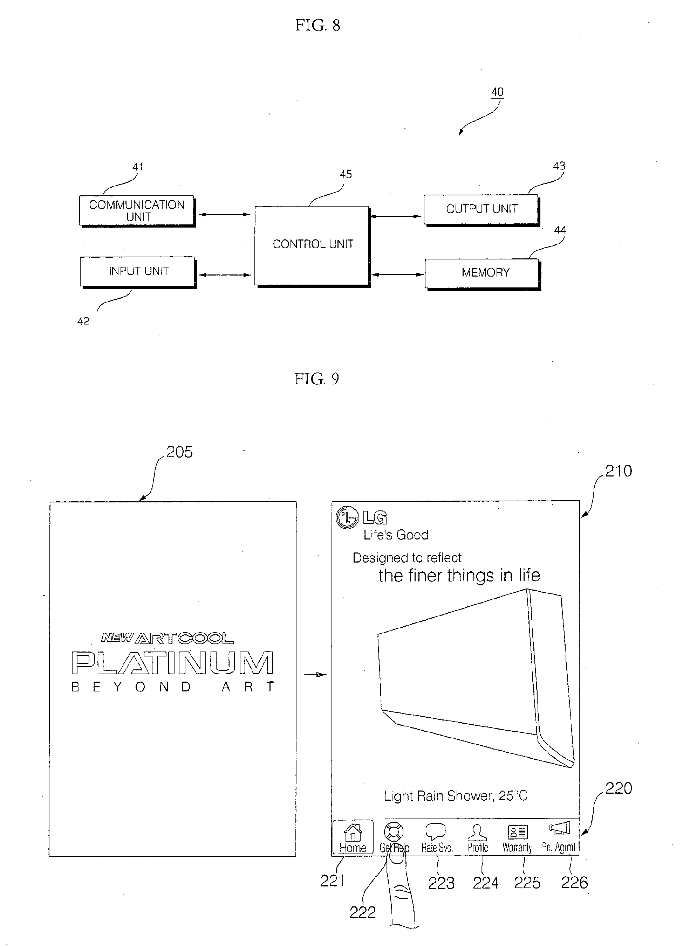

When a user's electronic device operates abnormally, a user requests service through the user mobile terminal 10 in operation S110. This operation is accomplished through a User Interface (UI) provided through a user mobile terminal, as shown in FIGS. 9 to 17.

A manager may receive the service request through the manager mobile terminal 20. Especially, the service request from the user mobile terminal 10 may be transmitted to each of a plurality of manager mobile terminals 20 connected to a wireless communication network, and a manager, who confirms the service request, may transmit a service dispatch request to a plurality of technician mobile terminals 30 through the manager mobile terminal 20 in operation S120.

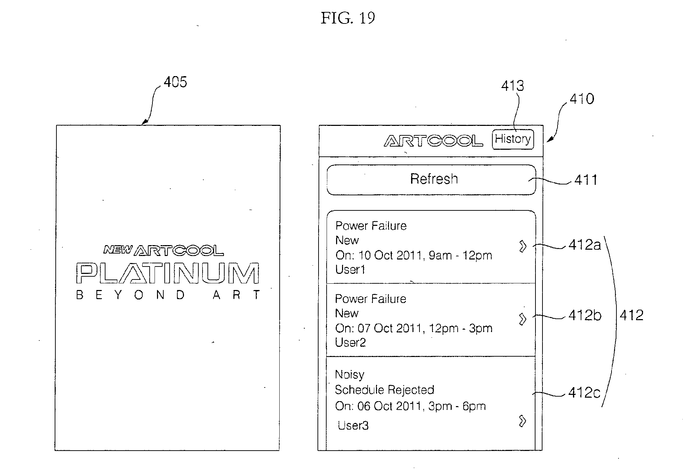

In more detail, a manager at a service provider, which provides service of electronic device (for example, After sale Service (AS)), confirms a service request from a user through the manager mobile terminal 20, and adjusts a service dispatch schedule in order to transmit a service dispatch request to a technician in operation S120. The operation may be accomplished through a UI provided through a manager mobile terminal, as shown in FIGS. 19 to 23.

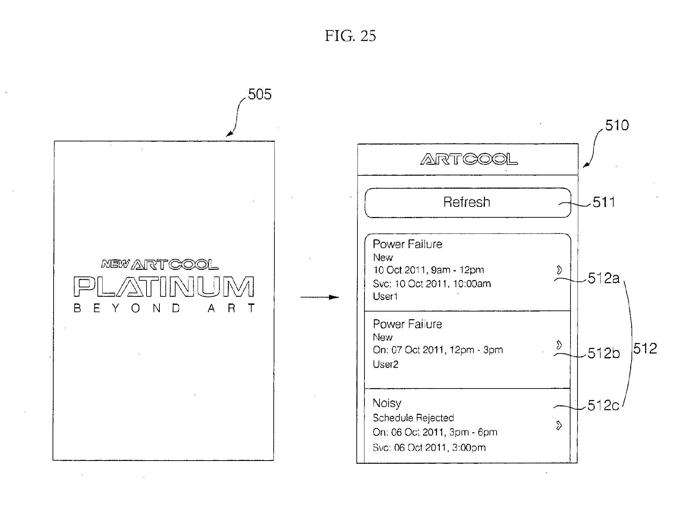

The service dispatch request in operation S120 may be notified to each of the plurality of technician mobile terminals 30, and each technician, who confirms the notification, may notify a response to the service dispatch request through the technician mobile terminal 30 in operation S130. The response to the service dispatch request is to notify whether to accept the service dispatch request to the manager mobile terminal 20 or the user mobile terminal 10 through the technician mobile terminal 30. This operation is accomplished through a UI provided through a technician mobile terminal, as shown in FIGS. 25 to 26.

When a technician responds to the service dispatch request through the technician mobile terminal 30, its result may be notified to the user mobile terminal 10 in addition to the manager mobile terminal 20. For example, both the response to the service request of FIG. 2 in operation S140 and the response to the service request in operation S150 are notified to the user mobile terminal 10. The response to the service request in operation S140 is notified from the technician mobile terminal 30 to the user mobile terminal 10. The response to the service request in operation S150 is notified from the manager mobile terminal 20 to the user mobile terminal 10 on the basis of the service dispatch response in operation S130. When one of a plurality of technicians accepts the service dispatch request in operation S120, the message that the service dispatch is accepted is notified to the manager mobile terminal 20 in operation S130, and also to the user mobile terminal 10 in operation S140 and operation S150.

Furthermore, when a rejection response to the service dispatch request is received from all of a plurality of technicians through the manager mobile terminal 20, this is not immediately notified to the user mobile terminal 10, and a manager readjusts a service dispatch schedule and notify it to the technician mobile terminals 30. In this case, the response to the service request in operation S140 or operation S150 may be notified after a technician accepts the adjusted service dispatch schedule.

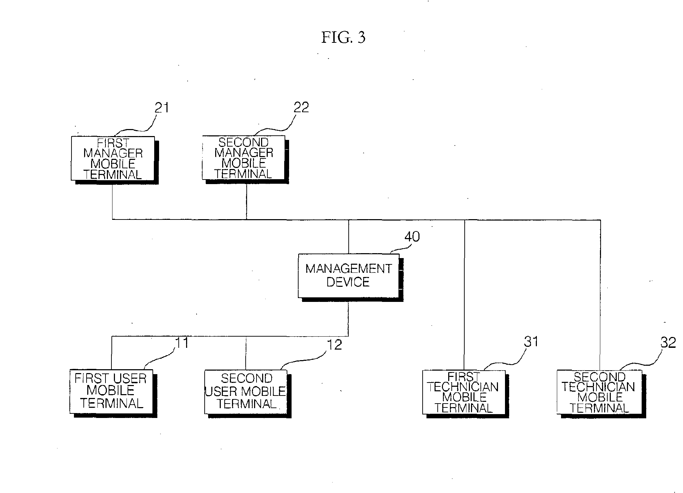

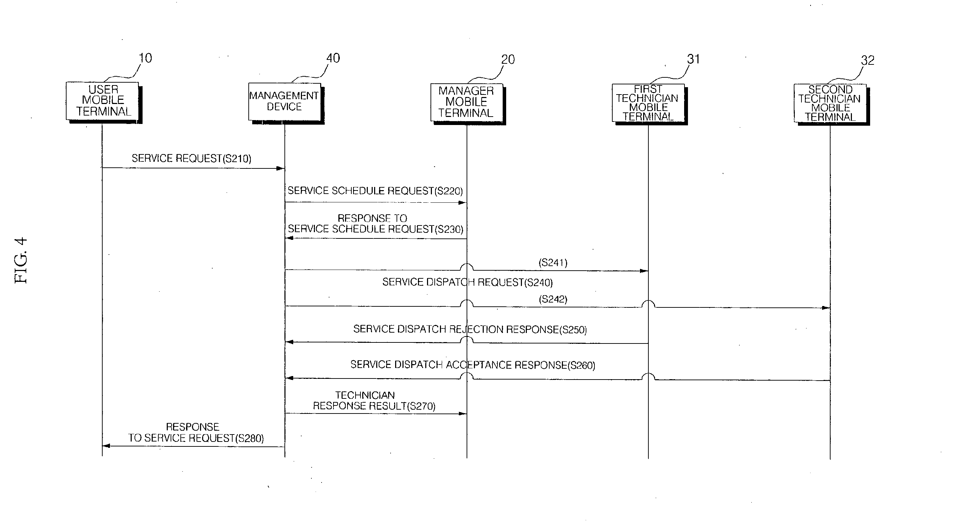

FIG. 3 is a block diagram illustrating an electronic device service system according to an embodiment of the present invention. FIG. 4 is a flowchart illustrating an operation for processing a service request through the electronic device service system of FIG. 3. FIG. 8 is a block diagram illustrating important components of the management device of FIG. 3.

As described with reference to FIGS. 1 and 2, the user mobile terminal 10, the manager mobile terminal 20, and the technician mobile terminal 30 are mutually connected to each other in the electronic device service system shown in FIGS. 3 and 4. However, the management device 40 may not necessarily include a communication unit for wireless communication, and may be connected to the wireless communication network via a wire. That is, unlike a mobile terminal, portability may not be considered when the management device 40 is configured. For example, when the management device 40 is connected to internet via a wire and a user accesses the internet via a Wi-Fi through the user mobile terminal 10, the service request S210 may be transmitted from the user mobile terminal 10 to the management device 40, and the response to the service request may be transmitted from the management device 40 to the user mobile terminal 10 in operation S280. In the same manner, it is apparent that the manager mobile terminal 20 or the technician mobile terminal 30 are connected to the internet via a wireless communication network, and the management device 40 is connected to the internet via a wire.

In the electronic device service system of FIG. 3, the user mobile terminal 10, the manager mobile terminal 20, or the technician mobile terminal 30 may be provided in plurality. Hereinafter, for convenience of description, the prefix "first" or "second" is assigned in order to distinguish each mobile terminal, but the mobile terminals 10, 20, and 30 of FIG. 1 are identical.

Moreover, the management device 40 may be an application server that processes requests, responses, and various kinds of information, which are transmitted between a user mobile terminal (i.e. a client), a manager mobile terminal, and a technician mobile terminal.

Referring to FIG. 8, the management device 40 may include a communication unit 41 (as described above, regardless of a wired/wireless communication) for communication between the mobile terminals 10, 20, and 30, i.e. clients, an input unit 42 for receiving a predetermined control command for controlling an operation of the management device 40, an output unit 43 for displaying information processed in the management device 40, a memory 44 for storing predetermined information, and a control unit 45 for controlling general operations of the management device 40 through an operation control of the each component.

When such components are implemented in actual application, at least two components are integrated into one component, or one component is divided into at least two components, if necessary.

According to an embodiment of the present invention, FIG. 4 illustrates how to process a service dispatch request for a plurality of technicians (hereinafter, which include two persons, i.e. a first technician and a second technician as an example) and a response to the service dispatch request, when a user makes a service request for an electronic device through the user mobile terminal 10.

Referring to FIG. 4, when an event occurs according to the service request in S210 from the user mobile terminal 10, the management device 40 notifies to the manager mobile terminal 20 that there is a service request. Service request information, which is transmitted from the user mobile terminal 10 to the management device 40, includes information on a schedule that a user wants to receive service (hereinafter, referred to as a "service request schedule'), and then, the information is transmitted to the mobile terminal 20 through the management device 40 in operation S220.

Additionally, during the service request in operation S210, user information such as a user address and contact, information on an unusual symptom of an electronic device are transmitted together in addition to the service request schedule. The information may be stored in the memory 44 of the management device 40.

When a request for a service schedule is received through the manager mobile terminal 20 in operation S220, a manager may adjust a service dispatch schedule (a schedule on when a technician visits a user) in response to the request through the manager mobile terminal 20, and the adjusted service dispatch schedule may be transmitted to the management device 40 through the manager mobile terminal 20 in operation S230.

When the service dispatch schedule is adjusted, the manager may consider the service request schedule. That is, the manager confirms a service request schedule through the manager mobile terminal 20, and notifies to the management device 40 a service dispatch schedule adjusted based on the service request schedule in operation S230.

The management device 40 requests a service dispatch to the technician mobile terminals 31 and 32 on the basis of the response in operation S230 to the service schedule request received from the manager mobile terminal 20 in operation S240. During the service dispatch request in operation S240, user information on a service request schedule and a user address and contact and information on an unusual symptom of an electronic device are transmitted together in addition to the service dispatch request.

The service dispatch request in operation S240 may be notified to each of a plurality of technician mobile terminals 31 and 32. In FIG. 4, the service dispatch requests in operation S241 and operation S242 are notified to the first technician mobile terminal 31 and the second technician mobile terminal 32.

The first technician and the second technician confirm a service dispatch request through the technician mobile terminals 31 and 32, and notify the response to the service dispatch request to the management device 40 in operation S250 and operation S260.

In response to the service dispatch request, technicians may select whether to accept or reject the request. For example, when the first technician transmits a rejection response to the service dispatch request in operation S241 to the management device 40 through the technician mobile terminal 31, and the second technician transmits an acceptance response to the service dispatch request in operation S241 to the management device 40 through the technician mobile terminal 32 in operation S260, the management device 40 may notify the response in operation S280 to a service request to the user mobile terminal 10 according to the technicians' responses. According to this embodiment, since the second technician accepts the service dispatch, acceptance on a user's service request is notified to the user mobile terminal 10.

Moreover, the management device 40 may notify the response results of technicians on a service dispatch request to the manager mobile terminal 20 in operation S270. Accordingly, if all technicians reject the service dispatch request, a manager may confirm a technician's response result through the manager mobile terminal 20, and may readjust a service dispatch schedule.

In more detail, if rejection responses to the service dispatch request are transmitted from the first technician and the second technician (i.e. all technicians who receive the service dispatch request), the management device 40 notifies the message that a service dispatch request is rejected from all technicians to the manager mobile terminal 20, and the manager readjusts a service dispatch schedule in order to transmit a service patch request according to the readjusted service patch schedule to the technician mobile terminals 31 and 32. This is more preferable than the case that the management device 40 notifies rejection on the service request to the user mobile terminal 10.

Moreover, in order to increase a service provision rate on a user's service request and efficiently manage technicians (i.e. service providing resources), a service dispatch schedule needs to be further specified and adjusted within a service request range requested by a user, through the manager mobile terminal 20.

For example, a UI provided through the user mobile terminal 10 may be implemented in order to select and input one of 9:00am∼12:00pm, 12:00pm∼3:00pm, and 3:00pm∼6:00pm as a service request schedule. In this case, when a user selects 9:00am∼12:00pm as a service request schedule and its result is transmitted to the manager mobile terminal 20 via a wireless communication network, a UI provided through the manager mobile terminal 20 may be implemented in order to select and input one of 9:00am∼10:00am, 10:00am∼11:00am, and 11:00am∼12:00pm as a service dispatch schedule.

In the above example, when a manager primarily selects 9:00am∼10:00am as a service dispatch schedule and notifies it to the technician mobile terminals 31 and 32, if there is a rejection response to the service dispatch request from all the technician mobile terminals 31 and 32, the manager readjusts one of the remaining 10:00am∼11:00am and 11:00am∼12:00pm as a dispatch schedule, and then, again notifies it to the technician mobile terminals 31 and 32.

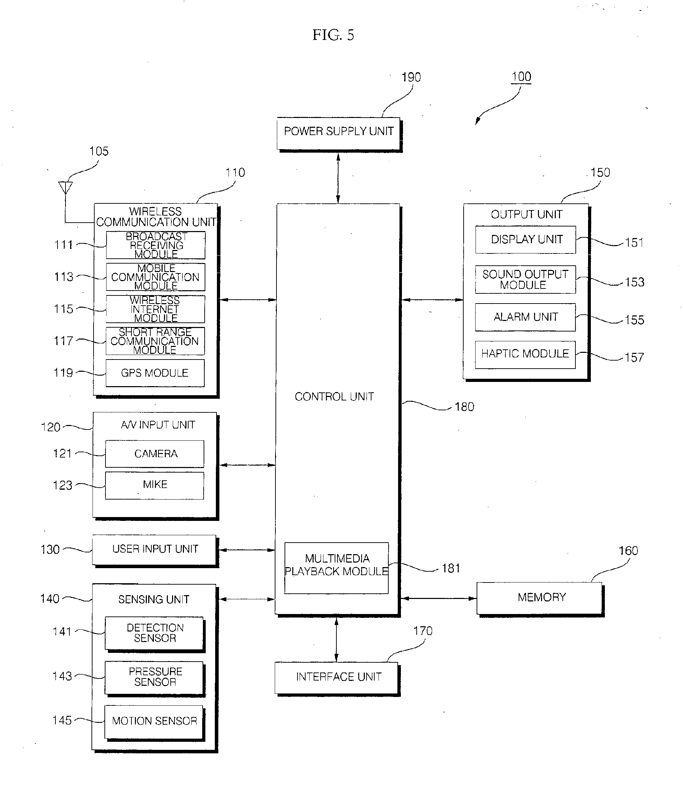

FIG. 5 is a block diagram illustrating main components of a mobile terminal according to an embodiment of the present invention. Hereinafter, referring to FIG. 5, the mobile terminal according to an embodiment of the present invention will be described from the point of view of configuration.

Any one of a user mobile terminal, a manager mobile terminal, and a technician mobile terminal is implemented with a mobile terminal 100 described below. A UI provided through each mobile terminal may vary according to applications stored in a memory and control unit's processing driven by the applications.

Referring to FIG. 5, the mobile terminal 100 may include a wireless communication unit 110, an Audio/Video (A/V) input unit 120, a user input unit 130, a sensing unit 140, an output unit 150, a memory 160, an interface unit 170, a control unit 180, and a power supply unit 190. When such components are implemented in actual application, at least two components are integrated into one component, or one component is divided into at least two components, if necessary.

The wireless communication unit 110 may include a broadcast receiving module 111, a mobile communication module 113, a wireless internet module 115, a short-range communication module 117, and a GPS module 119.

The broadcast receiving module 111 receives at least one of a broadcast signal and broadcast related information from an external broadcast management server through a broadcast channel. At this point, the broadcast channel may include a satellite channel and a terrestrial wave channel. The broadcast management service may refer to a server for generating and transmitting at least one of a broadcast signal and broadcast related information, or a server for receiving at least one of a pre-generated broadcast signal and broadcast related information and transmitting it to a terminal.

The broadcast signal may include a TV broadcast signal, a radio broadcast signal, a data broadcast signal, and furthermore may have a broadcast signal format that a data broadcast signal is combined with a TV broadcast signal or a radio broadcast signal. The broadcast related information may refer to information on a broadcast channel, a broadcast program, or a broadcast service provider. The broadcast related information may be provided via a mobile communication network. In this case, it is received by the mobile communication module 113. The broadcast related information may have various formats. For example, the broadcast related information may have a format such as an Electronic Program Guide (EPG) of a Digital Multimedia Broadcasting (DMB), or an Electronic Service Guide (ESG) of a Digital Video Broadcast-Handheld (DVB-H).

The broadcast receiving module 111 receives a broadcast signal by using various broadcasting system, and receives a digital broadcast signal by especially using Digital Multimedia Broadcasting-Terrestrial (DMB-T), Digital Multimedia Broadcasting-Satellite (DMB-S), Media Forward Link Only (MediaFLO), Digital Video Broadcast-Handheld (DVB-H), and Integrated Services Digital Broadcast-Terrestrial (ISDB-T). Additionally, the broadcast receiving module 111 may be configured to fit for all broadcasting systems providing a broadcast signal in addition to such a digital broadcasting system. A broadcast signal and/or broadcast related information received through the broadcast receiving module 111 may be stored in the memory 160.

The mobile communication module 113 transmits/receives a wireless signal to/from at least one of a base station, an external terminal, and a server on a mobile communication network. Here, the wireless signal may include a voice call signal, a video call signal, or various forms of data according to text/multimedia message transmission.

The wireless internet module 115 refers to a module for wireless internet connection, and may be built in or mounted on the mobile terminal 100. A wireless internet technique may include Wireless LAN (WLAN), Wi-Fi, Wireless broadband (Wibro), World Interoperability for Microwave Access (Wimax), and High Speed Downlink Packet Access (HSDPA).

The short-range communication module 117 refers to a module for short-range communication. A short-range communication technique may include Bluetooth, Radio Frequency Identification (RFID), infrared Data Association (IrDA), Ultra Wideband (UWB), and ZigBee.

The Global Position System (GPD) module 119 receives position information from a plurality of GPS satellites.

The A/V input unit 120 is for inputting an audio signal or a video signal and may include a camera 121 and a microphonemicrophone 123. The camera 121 processes an image frame of a sill image or video obtained by an image sensor in a video call mode or a capturing mode. Then, the processed image frame may be displayed on the display unit 151.

The image frame processed by the camera 121 may be stored in the memory 160 or may be transmitted to an external through the wireless communication unit 110. At least two cameras 121 may be provided according to a configuration aspect of a terminal.

The microphone 123 receives an external sound signal from a microphone in a call mode, a recording mode, or a voice recognition mode, and then, processes the received sound signal as electrical voice data. Then, the processed voice data are converted into a format that they are transmitted to a mobile communication base station through the mobile communication module 113, and then are outputted in a call mode. The microphone 123 may use various noise reduction algorithms in order to reduce noise occurring when an external sound signal is received.

The user input unit 130 generates key input data when a user's input is provided in order to control an operation of a terminal. The user input unit 130 may include a key pad, a dome switch, and a touch pad (a static pressure/electrostatic type), which receive a command or information through a user's push or touch operation. Additionally, the user input unit 130 may include a jog wheel or jog type for rotating a key, or a joystick type, or a finger mouse type. Especially, if a touch pad and the display unit 151 described later constitute a mutual layer structure, this may be called a touch screen.

The sensing unit 140 detects a current state of the mobile terminal 100 such as an opened/closed state of the mobile terminal 100, the position of the mobile terminal 100, and user's contact/no contact, and then, generates a sensing signal in order to control an operation of the mobile terminal 100. For example, if the mobile terminal 100 has a slide phone form, whether a slide phone is opened or closed is sensed. Furthermore, the sensing unit 140 may perform a sensing function, which relates to a power supply of the power supply unit 190 and an external device connection of the interface unit 170.

The sensing unit 140 may include a detection sensor 141, a pressure sensor 143, and a motion sensor 145. The detection sensor 141 detects whether there is an object approaching the mobile terminal 100 or whether there is an object around the mobile terminal 100, without mechanical contact. The detection sensor 141 may detect an adjacent object by using a change in AC magnetic field, a change in static magnetic field, or a change rate in capacitance. At least two detection sensors 141 may be provided according to a configuration aspect.

The pressure sensor 143 may detect whether pressure is applied to the mobile terminal 100 and the size of the pressure. The pressure sensor 143 may be installed at a portion necessary for detecting a pressure in the mobile terminal 100 according to a usage environment. If the pressure sensor 143 is installed at the display unit 151, according to a signal outputted from the pressure sensor 143, a touch input through the display unit 151 and a pressure touch input having a greater applied pressure than the touch input may be identified. Additionally, according to a signal outputted from the pressure sensor 143, the size of a pressure applied to the display unit 151 may be obtained during pressure touch input.

The motion sensor 145 may detect the position or movement of the mobile terminal 100 by using an acceleration sensor and a gyro sensor. An acceleration sensor used for the motion sensor 145 is a device for converting an acceleration change in one direction into an electrical signal, and is extensively used as a micro-electromechanical systems (MEMS) technique is developed. There are various kinds of acceleration sensor, which are built in an airbag system of a vehicle in order to measure a large value of acceleration used for detecting a collision, and are used to measure a small value of acceleration used for input means of a game by recognizing a small operation of the human hand. An acceleration sensor typically includes two axes or three axes mounted in one package or may require only one axis (for example, a z-axis) according to a usage environment. Accordingly, for some reason, when an acceleration sensor of an X-axis or Y-axis direction, instead of a Z-axis direction, needs to be used, an additional piece of a substrate is used to vertically mount the acceleration sensor on a motherboard.

Additionally, a gyro sensor measures an angular speed and detects a twisted direction with respect to a reference direction.

The output unit 150 outputs an audio signal, a video signal, or an alarm signal. The output unit 150 may include a display unit 151, a sound outputting module 153, an alarm unit 155, and a haptic module 157.

The display unit 151 displays information processed in the mobile terminal 100. For example, when the mobile terminal 100 is in a call mode, the display unit 151 displays a UI or Graphic User Interface (GUI) relating to a call. Moreover, when the mobile terminal 100 is in a video call mode or a capturing mode, the display unit 151 displays captured or received images separately or simultaneously, and a UI or GUI.

Moreover, as mentioned above, when the display unit 151 and a touch pad constitute a touch screen with a mutual layer structure, the display unit 151 may be used as an input device that receives information by a user's touch in addition to an output device.

If the display unit 151 is implemented with a touch screen, it may include a touch screen panel and a touch screen panel controller. In this case, the touch screen panel is a transparent panel attached to the outside of the mobile terminal 100 and is connected to an internal bus of the mobile terminal 100. If there is a touch input during contact result observation, the touch screen panel transmits corresponding signals to the touch screen panel controller. The touch screen panel controller processes the signals and transmits corresponding data to the control unit 180 in order to allow the control unit 180 to recognize whether there is a touch input or which area of the touch screen is touched.

The display unit 151 may be configured with e-paper. E-paper is a sort of reflective display and has excellent viewing characteristics like typical paper and ink such as high resolution, wide viewing angle, and bright white background. E-paper may be implemented on any substrate such as plastic, metal, and paper, retains an image even after no power is applied, and maintains the battery life of the mobile terminal 100 longer because of no power for a backlight. A hemispherical twist ball charged with electrostatic or an electrophoresis micro capsule may be used as e-paper.

Besides that, the display unit 151 may include at least one of a liquid crystal display, a thin film transistor-liquid crystal display, an organic light-emitting diode, a flexible display, and a 3D display. Also, at least two display units 151 may be provided according to an implementation form of the mobile terminal 100. For example, an external display unit (not shown) and an internal display unit (not shown) may be simultaneously equipped in the mobile terminal 100.

The sound outputting module 153 outputs audio data received from the wireless communication unit 110 or stored in the memory 160 in a call signal reception mode, a call mode, a recording mode, a voice recognition mode, and a broadcast reception mode. Additionally, the sound outputting module 153 outputs the sound signal of a function performed in the mobile terminal 100, which relates to call signal reception sound and message reception sound. The sound outputting module 153 may include a speaker and a buzzer.

The alarm unit 155 outputs a signal for notifying event occurrence of the mobile terminal 100. An example of an event occurring in the mobile terminal 100 includes call signal reception, message reception, and key signal input. The alarm unit 155 outputs a signal for notifying event occurrence in a different format than an audio signal or a video signal. For example, the alarm unit 155 outputs a signal in a vibration form. When a call signal or a message is received, the alarm unit 155 may output a signal for notifying the reception. Additionally, when a key signal is inputted, the alarm unit 155 may output a signal as a feedback on the key signal input. A user may recognize event occurrence through a signal that the alarm unit 155 outputs. A signal for event occurrence notification may be outputted through the display unit 151 or the sound outputting module 153 in the mobile terminal 100.

The haptic module 157 generates various haptic effects that a user can feel. A typical example of haptic effect that the haptic module 157 generates is vibration effect. When the haptic module 157 generates vibration as haptic effect, the intensity and pattern of vibration that the haptic module 157 generates may vary and respectively different vibrations may be combined and outputted, or sequentially outputted.

Besides the vibration, the haptic module 157 may generate various haptic effects such as an effect by stimulation due to an arrangement of pins that vertically move with respect to a skin contact surface, an effect by stimulation due to injection power of suction power of air through a nozzle or inlet, an effect by stimulation due to rubbing against a skin surface, an effect by stimulation due to electrode contact, an effect by stimulation due to static electricity, and an effect by cold and warm sense reproduction using a heat suctioning or emitting device. The haptic module 157 may deliver haptic effect through direct contact and may be implemented to provide haptic effect through muscle sense such as a user's finger or arm. At least two haptic modules 157 may be provided according to a configuration aspect.

The memory 160 may store programs for processing and controlling of the control unit 180, and may serve as a temporary storage of input or output data (for, example, a phonebook, a message, a still image, and a video). Additionally, an application for UI described later may be stored in the memory 160.

The memory 160 may include at least one type of storage medium among a flash memory type, a hard disk type, a multimedia card micro type, a card type (for example, SD or XD memory), a RAM type, and a ROM type. Additionally, the mobile terminal 100 operates a web storage for performing the storage function of the memory 150 on internet.

The interface unit 170 serves as an interface with all external devices connected to the mobile terminal 100. Examples of an external device connected to the mobile terminal 100 include a wired/wireless headset, an external charger, a wired/wireless data port, a card socket (for example, a memory card, a Subscriber Identification Module (SIM) card, and a User Identity Module (UIM) card), an audio Input/Output (I/O) terminal, a video I/O terminal, and an earphone. The interface unit 170 may receive data from such an external device or power, and then may deliver it to each component in the mobile terminal 100 or may transmit data in the mobile terminal 100 to an external device.

When the mobile terminal 100 is connected to an external cradle, the interface unit 170 may be a path through which the power from the connected cradle is supplied to the mobile terminal 1100, or a path through which various command signals inputted by a user from the cradle are delivered to the mobile terminal 100.

The control unit 180 typically controls an operation of the each component in order to control overall operations of the mobile terminal 100. For example, the control unit 180 performs controlling and processing operations relating to voice call, data communication, and video call. Furthermore, the control unit 180 may include a multimedia playback module 181 for playing multimedia. The multimedia playback module 181 may be configured as hardware in the control unit 180, or as software separated from the control unit 180.

Moreover, the power supply unit 190 may receive external power or internal power according to a control of the control unit 180 in order to provide power necessary for an operation of each component.

The mobile terminal 100 having such a configuration includes a wired/wireless communication system and a satellite based communication system in order to allow an operation in a communication system that transmits data through a frame or a packet.

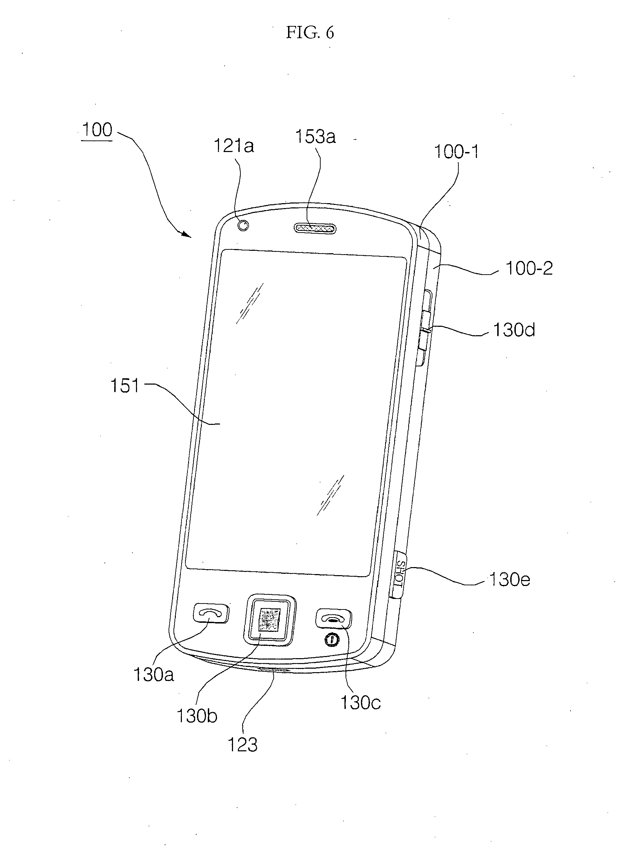

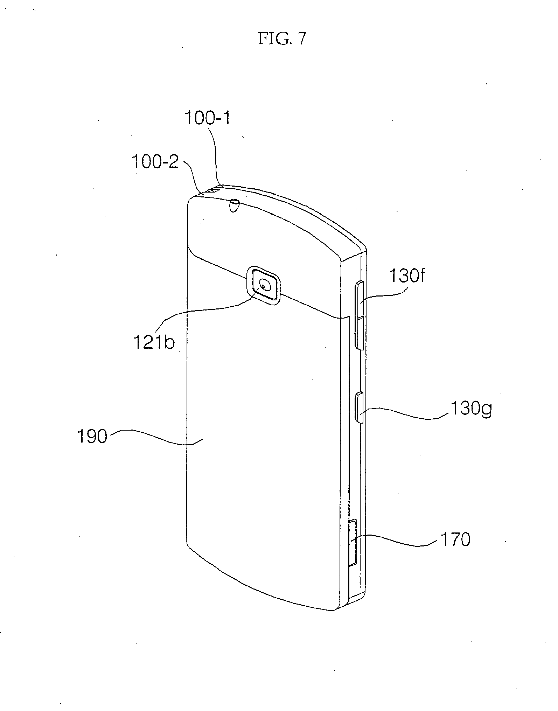

FIG. 6 is a perspective view as seen from the front of a mobile terminal according to an embodiment of the present invention. FIG. 7 is a perspective view as seen from the rear of a mobile terminal according to an embodiment of the present invention. Hereinafter, referring to FIGS. 6 and 7, a mobile terminal relating to the present invention will be examined from the perspective of a component according to the appearance.

Additionally, hereinafter, for convenience of description, among several types of mobile terminals such as a folder type, a bar type, a swing type, and a slide type, a bar type mobile terminal equipped with a front touch screen will be described as an example. However, the present invention is not limited to the bar type mobile terminal, and thus, may be applicable to all types of mobile terminals including the above-mentioned types.

Referring to FIG. 6, a case constituting the appearance of the mobile terminal 100 includes a front case 100-1 and a rear case 100-2. Various kinds of electronic components are built in a space formed by the front case 100-1 and the rear case 100-2. The front case 100-1 and the rear case 100-2 may be formed by injecting synthetic resin, or may be formed of metal such as stainless steel (STS) or titanium (Ti).

A display unit 151, a first sound outputting module 153a, a first camera 121a, and first to third user input units 130a, 130b, and 130c may be disposed at the main body, i.e. the front case 100-1. Also, a fourth user input unit 130d, a fifth user input unit 130e, and a microphone 123 may be disposed at the side of the rear case 100-2.

The display unit 151 includes overlapping touch pads in a layer structure, and thus operates as a touch screen to allow information input by a user's touch.

The first sound outputting module 153a may be implemented with a receiver or speaker form. The first camera 121a may be implemented with an appropriate form for capturing an image or video of a user. Also, the microphone 123 may be implemented with an appropriate form for receiving user's voice and other sounds.

First to fifth user input units 130a, 130b, 130c, 130d, and 130e and sixth and seventh user input units 130f and 130g described later may be called a user input unit 130. Any manner may be adopted if a user manipulates them with tactile feeling (i.e. a tactile manner).

For example, the user input unit 130 may implemented with a key pad, a dome switch, and a touch pad, which receive a command or information through a user's push or touch operation, or may be implemented with a wheel or jog type for rotating a key or a joystick type. On the functional aspect, the first to third user input units 130a, 130b, and 130c are for inputting commands such as start, end, and scroll, and the fourth user input unit 130d is for inputting the selection of an operation mode. Additionally, the fifth user input unit 130e may operate as a hot-key for activating a specific function of the mobile terminal 100.

Referring to FIG. 7, a second camera 121b may be additionally mounted on the rear of the rear case 100-2, and the sixth and seventh user input units 130f and 130g and the interface unit 170 may be disposed at the side of the rear case 100-2.

The second camera 121b may have a capturing direction that is substantially opposite to that of the first camera 121a, and may have different pixels than the first camera 121a. A flash (not shown) and a mirror (not shown) may be additionally disposed adjacent to the second camera 121b. Additionally, another camera is further installed adjacent to the second camera 121b in order to capture a 3-d image.

The flash emits light toward a subject when the second camera 121b captures the object. The mirror is used to reflect a user's face when the user shoots himself/herself (i.e. self-shooting) by using the second camera 121b.

A second sound outputting module (not shown) may be additionally disposed at the rear case 100-2. The second sound outputting module may implement a stereo function together with the first sound outputting module 153a, and may be used for a call in a speaker phone.

The interface unit 170 may be used as a path through which data are exchanged with an external device. Also, in addition to an antenna for call, an antenna (not shown) for receiving a broadcast signal may be disposed at one area of the front case 100-1 and the rear case 100-2. The antenna may be installed to be drawn from the rear case 100-2.

A power supply unit 190 may be mounted on the rear case 100-2 in order to supply power to the mobile terminal 100. For example, the power supply unit 190 as a rechargeable battery may be detachable to the rear case 100-2 in order for charging.

In the above, the second camera 212b is disposed at the rear case 100-2, but the present invention is not limited thereto. Additionally, even when the second camera 121b is not additionally equipped, the first camera 121a may be configured to be rotatable in order to capture an image in the capturing direction of the second camera 121b.

Hereinafter, referring to FIGS. 9 to 17, a UI provided through the user mobile terminal 10 will be described. The UI is implemented by driving a specific application stored in the memory 160 of the user mobile terminal 10. The application may be provided together with a mobile terminal, and may be downloaded by accessing an application web server on internet. Especially, the user mobile terminal 10 should be understood as a sort of recording medium for storing application. This is the same when an application is downloaded via internet.

FIG. 9 is a screen view displayed through a display unit of a user mobile terminal according to an embodiment of the present invention. Hereinafter, the user mobile terminal 10 follows the configuration of the mobile terminal 100 described with reference to FIGS. 5 to 7.

Referring to FIG. 9, once a specific application is driven through the user mobile terminal 10, an initial screen 205 is displayed, and then, a main screen 210 is displayed through the display unit 151. The control unit 180 calls and drives an application stored in the memory 160, and controls the initial screen 205 and the main screen 210 to be sequentially displayed through the display unit 151.

While the initial screen 205 is displayed, the control unit 180 may control the wireless communication unit 110 to attempt an access to a wireless communication network. Once the connection is made, the control unit 180 updates the memory 160 by receiving updated information from the management device 40, and also receives additionally information on accessed area weather (for example, 'Light Rain Shower') and temperature (for example, '25°C') in order to display them on the main screen 210.

A main menu 220 is displayed on the main screen 210. The main menu 220 may include at least one of a main screen display menu 221, a service request menu 222, a service request list display menu 223, a user information input menu224, a warranty information input menu 225, and a user private information protection policy display menu 226. When the main menu 220 is displayed on the main screen 210, the main screen display menu 221, the service request menu 222, the service request list display menu 223, the user information input menu224, the warranty information input menu 225, and the user private information protection policy display menu 226 may be horizontally arranged at the bottom of the screen of the display unit 151.

When the main screen display menu 221 is selected during a UI operation, the display unit 151 displays the main screen 210.

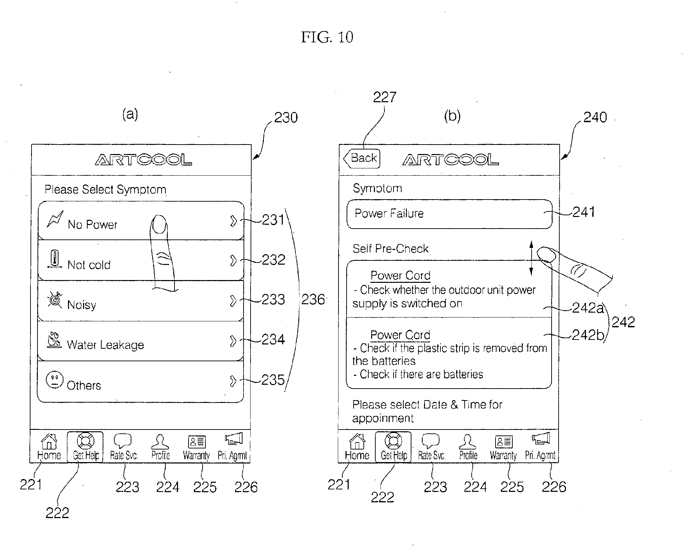

FIG. 10 is screen views displayed when the service request menu 222 is selected in FIG. 9. Referring to FIGS. 9 and 10, when the service request menu 222 is selected, the control unit 180 controls a screen 230 including an abnormal symptom list 236, which classifies abnormal symptoms of an electronic device by each item, to be displayed through the display unit 151.

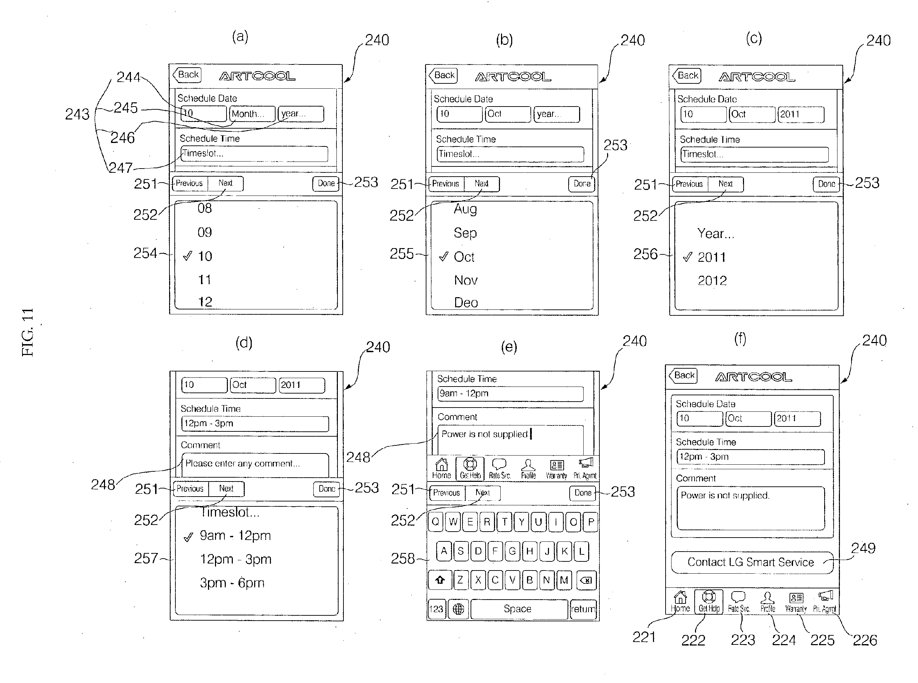

According to this embodiment, the abnormal symptom list 236 that classifies abnormal symptoms by each item, which frequently occur in an air conditioner, is displayed. In more detail, the abnormal symptom list 236 classifies abnormal symptoms occurring in an air conditioner into a power failure symptom item 231, an air conditioner capacity deterioration symptom item 232, a noise occurrence symptom item 233, a leakage symptom item 234, and a list of other symptoms, and displays them. When one of the items is selected, as shown in FIG. 10(b), simple steps relating to the selected item that a user can try by himself/herself may be displayed. For example, when the power failure symptom item 231 is selected as shown in FIG. 10(a), action information on power failure symptom may be displayed through the display unit 151 as shown in FIG. 10(b), and also, the screen 240 of FIG. 11 including a service request schedule input window 243 may be displayed. As shown in FIG. 10(b), due to the display area limitation of the display unit 151, the abnormal symptom 241 and the action information 242 on abnormal symptom are displayed first, and then, a scroll screen having the service request schedule input window 243 is displayed.

A user, who wants to request a service due to abnormality in an electronic device in use, first selects a corresponding abnormality symptom item from the abnormal symptom list 236 in order to confirm an action (for example, the power failure symptom item 231 is selected), and then, confirms whether the power of the outdoor unit of an air conditioner is turned on (refer to 242a), or attempts a simple self action that confirms whether a battery is normally mounted on (refer to 242b). However, even by doing that, if the abnormal symptom is not fixed, the user inputs a schedule for service and transmits it to the other side terminal, for example, the manager terminal 20, connected via a wireless communication network.

Moreover, the reference number 227 of FIG. 10 refers to a back to previous step menu that receives a selection on returning to a previous step.

In FIGS. 11(a) to 11(f), processes for inputting a schedule that a user wants to receive a service through a service request schedule input window 243 are sequentially shown. Hereinafter, the service request schedule input window 243 includes input windows 244, 245, 246, and 247 for inputting each of day, month, year, and time, but the present invention is not limited thereto. For example, it is apparent that a key pad is used to input a text by a user's push or touch operation.

When a day input window 244, a month input window 245, a year input window 246, and a time input window 247 are selected by a user's touch operation, each of a day selection input window 254, a month selection input window 255, a year selection input window 256, and a time selection input window 257 is displayed. Then, when a day, a month, a year, and a time are selected through the selection input windows 254, 255, 256, and 257, their results are respectively reflected on them 244, 245, 246, and 247. However, in terms of operating convenience, inputting a day, a month, a year, and a time sequentially by manipulating the back to previous step menu 251, the forward to next step menu 252, and the input confirmation menu 253 is better than inputting a service request schedule that a user wants to receive a service by separately selecting each of the input windows or selection input windows.

In more detail, as shown in FIG. 11(a), after a day is selected through the day selection input window 254 and then the forward to next step menu 252 is selected, as shown in FIG. 11(b), the month selection input window 255 is displayed. After a month is selected through the month selection input window 255 and then the forward to next step menu 252 is selected, as shown in FIG. 11(c), the year selection input window 256 is displayed. After a year is selected through the year selection input window 256 and then the forward to next step menu 252 is selected, as shown in FIG. 11(d), the time selection input window 257 is displayed.

The time selection input window 257 selects a time slot that a user wants to receive a service. According to this embodiment, a time slot divided by each 3 hr from 9:00 am is selected but the present invention is not limited thereto.

Moreover, an additional information input window 248 may be displayed on the screen 240 of FIG. 11. When the additional information input window 248 is selected, a text input window 258 may be displayed as shown in FIG. 11(e). After a user selects and inputs a time slot through the time selection input window 257, a service request schedule input is completed. Then, when a predetermined text is inputted through the text input window 258, the inputted contents are reflected on the additional information input window 248. In this embodiment, a simple message that power is not supplied due to an abnormal symptom of an air conditioner (i.e. a service subject) is inputted.

Then, once the input confirmation menu 253 is selected, as shown in FIG. 11(f), the service request transmission menu 249 is displayed. According to the selection input of the service request transmission menu 249, a service request schedule stored until now is transmitted to a wireless communication network through the wireless communication unit 110, and then, is transmitted to the other mobile terminal (for example, the manager mobile terminal 20) accessed to the wireless communication network.

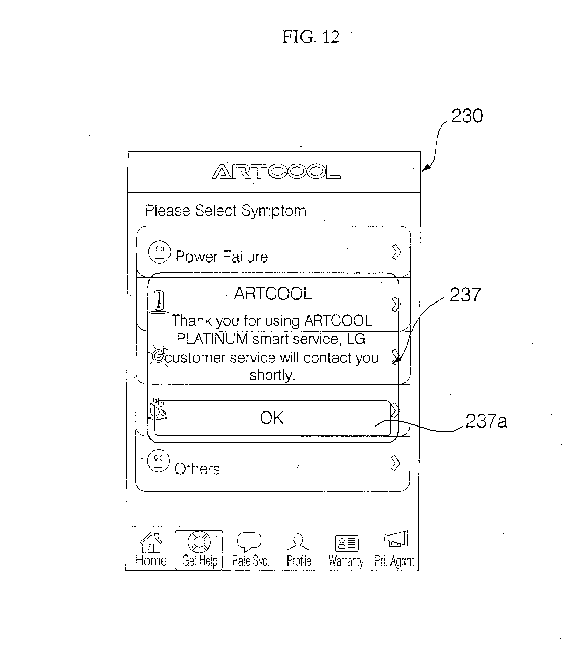

Fig. 12 is a screen including a transmission completion display window 237 for notifying that a service request schedule is normally transmitted via a wireless communication network through the processes described with reference to FIG. 11.

When the service request schedule inputted through the above-mentioned processes is normally transmitted through the wireless communication unit 110, the control unit 180 may control the output unit 150 to output a predetermined notification message. In this embodiment, the notification message is outputted through the transmission completion display window 237, but the present invention is not limited thereto. That is, the notification message may be outputted through the sound outputting module 153, the alarm unit 155, or the haptic module 157.

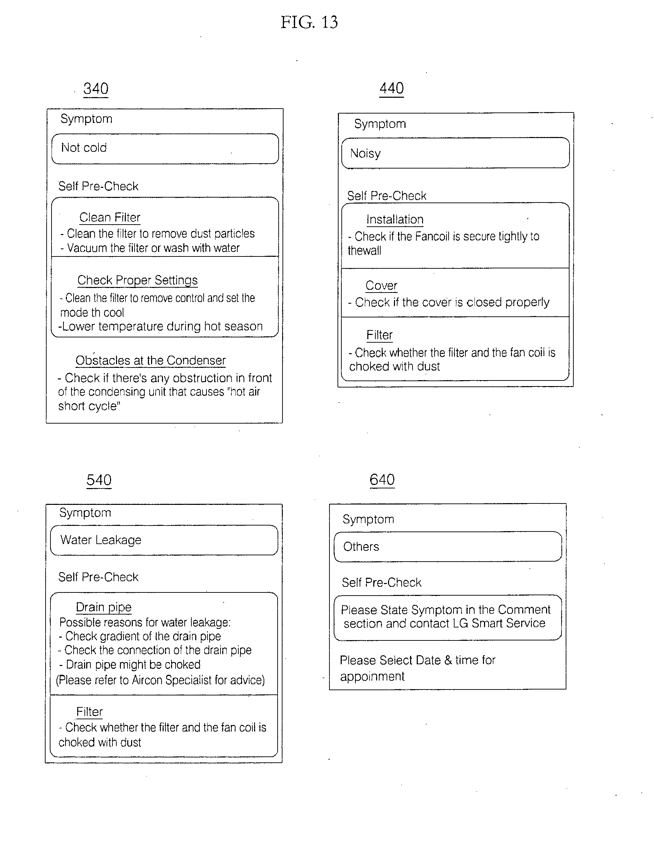

FIG. 13 is a view illustrating an abnormal symptom and action information on an electronic device, which are displayed through the display play unit 251, when items of the abnormal symptom list 236 are selected. In this embodiment, the screens 240, 340, 440, 540, and 640 including action information displayed are implemented in a manner that information is delivered through a text, but the present invention is not limited thereto. That is, the measures to be taken by a user may be implemented using images, videos, and voice instructions.

Moreover, action information may be updated through a communication network. That is, after whether update exists in the management device 40 is determined through the wireless communication unit 110 at the beginning of application execution, if the update exists, action information is updated through downloading.

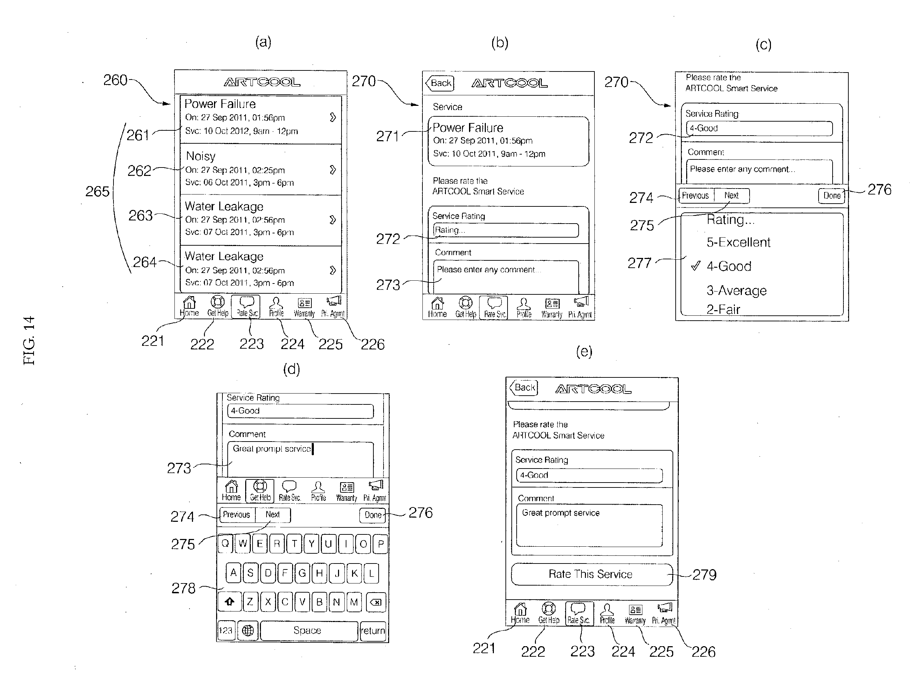

FIG. 14 is a view illustrating screens displayed through the display unit 151 of a user mobile terminal when the service request list display menu 223 is selected from the main menu 220. Especially, FIG. 14 is a view illustrating processes for inputting user satisfaction on service request completed items.

When the service request list display menu 223 is selected from the main menu 220, the control unit 180 controls the display unit 151 in order to display a screen 260 including a service request list 265 as shown in FIG. 14(a). The service request list 265 may be generated on the basis of service request information stored in the memory 160 or information received from the management device 40 via a wireless communication network. Completed four service request items 261, 262, 263, and 264 are shown in FIG. 14(a). Once one of the service request items, for example, the first service request item 261, is selected by a user's touch operation, as shown in FIG. 14(b), a screen 270 including a service processing detail on the selected service request item is displayed. The screen 270 displaying the service processing detail may include a service request detail display window 271 for displaying a processing detail on the selected service request item and a service satisfaction input window 272 for inputting service satisfaction on the processing completed service request item.

The service request detail display window 271 may include power failure of an electronic device that a user requests a service, service request date ('On: 27 Sep 2011, 01:56pm'), and a service request schedule (Svc: 10 Oct 2011, 9am-12pm').

The service satisfaction input window 272 receives satisfaction rating on the selected service request item, that is, the degree of satisfaction on the service completed service request item. Once the service satisfaction input window 272 is selected, as shown in FIG. 14(c), selectable ratings are separately displayed, and also a satisfaction selection input window 277 is displayed to select one of the ratings. Then, when service satisfaction is selected and inputted through the satisfaction selection input window 277, its result is displayed through the service satisfaction input window 272.

Then, once an input completion menu 276 or a next step progress menu 275 is selected, the satisfaction input is completed. Especially, once the next step progress menu 276 is selected, as shown in FIG. 14(d), a text input window 278 is displayed to input additional information, and the content inputted through the text input window 278 is reflected on the additional information input window 273. According to this embodiment, the message that service is immediately completed is inputted.

Then, once a service satisfaction transmission menu 179 shown in FIG. 14(e) is selected, the service satisfaction rating inputted through the service satisfaction input window 272 may be transmitted to the management device 40, the manager mobile terminal 20 and/or the technician mobile terminal 30 via a wireless communication network.

Moreover, the service request detail display window 271 may include a service completed service request detail and also a service reservation item on no technician's visiting. However, in this case, even when a user selects the service reservation item, the service satisfaction input window 272 or the service satisfaction transmission menu 279 may not be activated.

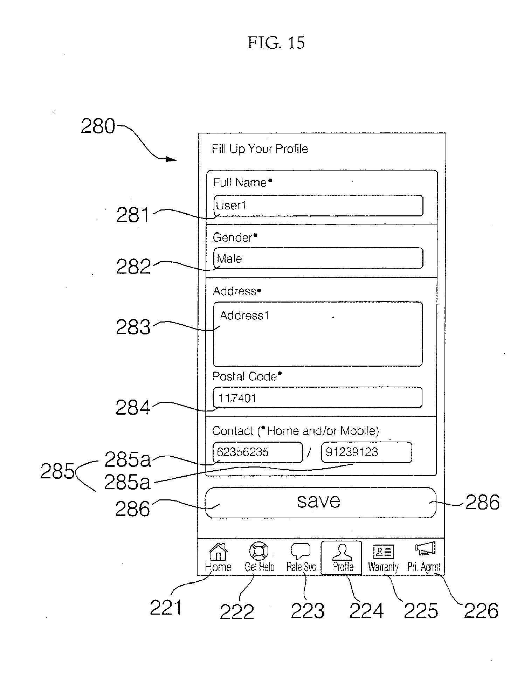

FIG. 15 is view illustrating a screen 280 displayed through the display unit 151 of the user mobile terminal 10 when a user information input menu 224 is selected from the main menu 220.

Referring to FIG. 15, the user information input window 280 may include a user name input window 281, a user gender input window 282, a user address input window 283, a user postal code input window 284, and/or a user contact input window 285. The user contact input window 285 may again include a user home phone number input window 285a and a user mobile phone number input window 285b.

Moreover, among the input windows, some input windows having required fields are indicated with a message or symbol ('•').

After contents for the required fields are inputted to the input windows completely, the inputted contents are stored in the memory 160, and also transmitted to the management device 40 via a wireless communication network in order to store them in the memory 44 of the management device 40. Additionally, user information may be transmitted to the other mobile terminal connected to a wireless communication network, for example, the manager mobile terminal 20 and/or the technician mobile terminal 30.

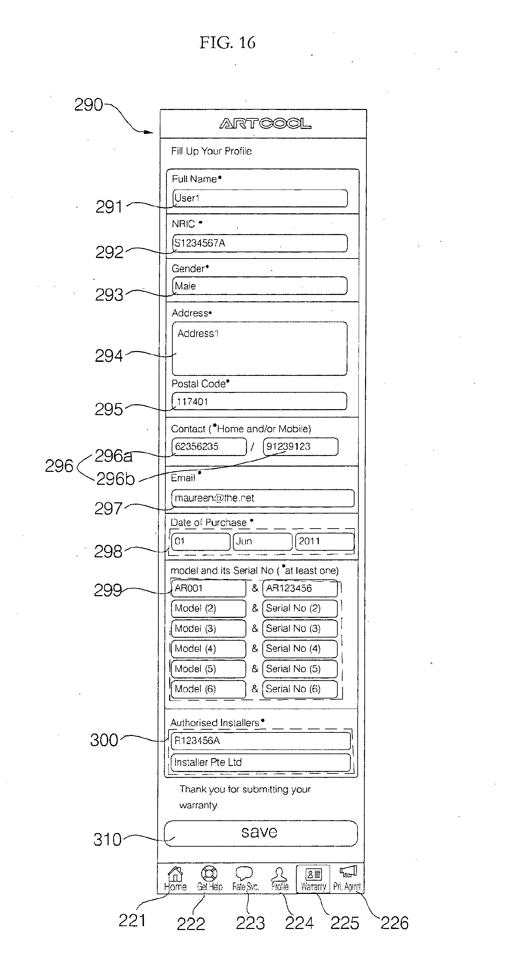

FIG. 16 is view illustrating a screen displayed through the display unit 151 of the user mobile terminal 10 when a warrantee information input menu 225 is selected.

Referring to FIG. 16, when the warrantee information input menu 225 is selected, the control unit 180 controls the display unit 151 to display a warrantee information input window 290. The warrantee information input window 290 is to receive warrantee information of an electronic device that a user purchases. The warrantee information is information that a manufacturer or seller manages in order to provide AS on an electronic device that a user purchases. Hereinafter, a purchaser and user of an electronic device are treated identically. The warrantee information may include purchase date information, device model information, device identification number (or serial number) information, and/or provider (or seller) information.

The warrantee information input window 290 may include a purchaser name input window 291, a purchaser National Registration Identity Card (NRIC) input window 292 (NRIC may be different depending on the country, in the case of Korea, social security number), a purchaser gender input window 293, a purchaser address input window 294, a purchaser address postal code input window 295, a purchaser contact input window 296 (including a purchaser home phone number 296a and a purchaser mobile phone number 296b), a purchaser e-mail input window 297, a purchase date input window 298, an electronic identification information input window 299 (for inputting model information ('Model') and serial number ('Serial No')), and/or a supplier information input window 300.

Especially, the identification information input window 299 may be implemented to receive model information and/or a serial number on a plurality of electronic devices. In such a way, even when an electronic device that is covered under warranty is an air conditioner (or, an air conditioning system) including a plurality of indoor units or outdoor units, information input and management become easy.

After general warrantee information is inputted through the warrantee information input window 290, if a warrantee information storage menu 310 is selected, the inputted warrantee information may be stored in the memory unit 160, or transmitted to the management device 40 through a wireless communication network.

Upon a service request later, the control unit 180 may load the pre-stored warrantee information from the memory unit 160, or may download the pre-stored warrantee information from the management device 40, so that a user does not need to re-input warrantee information.

Especially, device model information or a serial number is typically written on a warrantee paper provided when an electronic device is purchased. In this case, a user is required to register the product with reference to the contents on the warrantee paper through the mail. However, since its procedure is very annoying, the user tends to be reluctant to register the product. Especially, if there is a long term between the purchase date and the product registration, the warrantee paper is lost in many cases. As a result, a user may not receive the service when needed.

Recently, a product registration procedure is performed after accessing a homepage of an electronic device manufacturer by using a PC connected to internet. However, this procedure is only available in an environment where a PC is connected to internet, and the home page of the electronic device manufacturer typically provides various services in addition to the product registration service, and also includes services relating to diverse kinds of electronic devices managed through the homepage. Therefore, like the above warrantee paper, it is also very annoying for a user to register the product currently in use.

However, the UI displayed through a mobile terminal according to the present invention is very intuitive, and also warrantee information is inputted through a simple operation such as a touch or scroll operation. As a result, a product registration procedure becomes very simple. Furthermore, if the warrantee paper is lost, a serial number needs to be checked through a label attached to the case of an electronic device. However, according to the present invention, when considering the mobility of a mobile terminal, a user may easily confirm/input a serial number by carrying the mobile terminal around the electronic device.

Furthermore, when abnormality occurs, in some cases, more prompt services are required according to types of electronic devices. For example, in the case of an air conditioner, in terms of user satisfaction, manufacturer's reliability, and furthermore, brand value, it is very important to provide a prompt service in a high temperature environment such as summer or a tropical region in which the air conditioner is frequently used. However, when a service request is made through a PC, since a service request procedure is complex. A prompt service may not be provided, and also a procedure for confirming a service request process is troublesome, so that user's complains become increased. On the contrary, according to the present invention, a simple and prompt service request is possible through a mobile terminal and a response to the service request is immediately confirmed.

Moreover, when the warrantee information input menu 225 is selected or the service request transmission menu 249 is selected, the control unit 180 controls the display unit 151 to display the warrantee information input window 290. However, according to this case, it is determined that a user does not input warrantee information yet, and thus it is induced to input the warrantee information before a service request.

In the same manner, when the service request transmission menu 249 is selected, the control unit 180 may control the display unit 151 to display the user information input window 280 if it is determined that there is no user information previously inputted in the memory 45 of the management device 40.

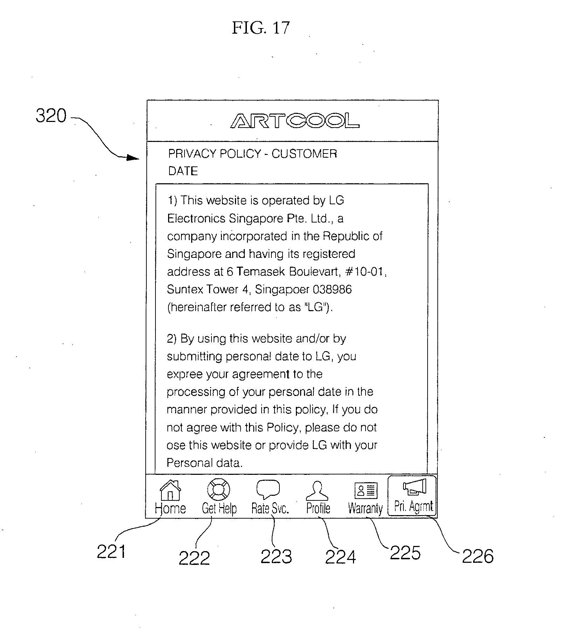

FIG. 17 is view illustrating a screen 320 displayed through the display unit 151 of a user mobile terminal when a private information protection policy menu 226 is selected from the main menu 220.

Referring to FIG. 17, when a private information protection display menu 226 is selected, a private information protection policy display window 320 including a private information protection policy for notifying that information transmitted from a user mobile terminal is available for a service provider, and conditions related to rights and obligations that other service providers notify to a user is provided. An input window (not shown) for receiving whether to agree on the content displayed through the private information protection policy display window 320 may be displayed on the display unit 151.

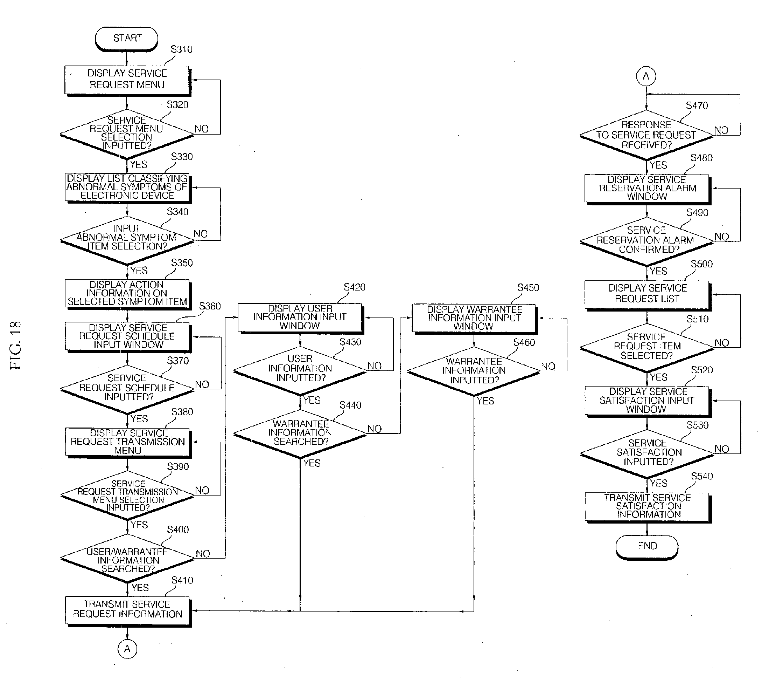

FIG. 18 is a flowchart illustrating a method of operating a user mobile terminal according to an embodiment of the present invention.

Referring to FIG. 18, the method of operating the user mobile terminal 10 includes: displaying a service request menu 222 through the display unit 151; receiving an input on selecting the service request menu 222 through the user input unit 130; displaying a service request schedule input window 243 in order to receive a desired schedule on receiving a service for an electronic device through the display unit 151 when the input on selecting the service request menu 222 is received; receiving the service request schedule through the service request schedule input window 243; and transmitting service request information on the basis of the information inputted through the service request schedule input window 243 to the other mobile terminal, for example, the manager mobile terminal 20, via a wireless communication network.

When a user, who wants to receive a service for an electronic device in use, executes an application in the user mobile terminal 10, the service request menu 222 is displayed through the display unit 151 in operation S310.

When the service request menu 222 is selected through the user input unit 130 in operation S320, the display unit 51 displays the abnormal symptom list 236 classifying abnormal symptoms of an electronic device by each item in operation S330.

When an item corresponding to an abnormal symptom of an electronic device is selected by a user from the abnormal symptom list 236, a screen for providing action information corresponding to the selected item is displayed through the display unit 151 in operation S350.

Additionally, the service request schedule input window 243 is displayed through the display unit 151 in operation S360. When the abnormal symptom of the electronic device cannot be resolved even after the action information is confirmed, the user selects the service request schedule input window 243 in order to input a desired schedule on receiving the service for the electronic device, that is, a service request schedule in operation S 370.

The service request transmission menu 249 for transmitting information inputted through the service request schedule input window 243 via a wireless communication network is displayed through the display unit 151 in operation S380. When the service request transmission menu 249 is inputted by a user's selection in operation S390, the control unit 180 searches the memory 160 of the user mobile terminal 10, or determines whether user information and warrantee information are pre-stored in access to the management device 40 through the wireless communication unit 110 in operation S400.

When it is determined that the user information and the warrantee information are pre-stored in operation S400, service request information inputted through the service request schedule input window 243 is transmitted via a wireless communication network. Then, the service request information is transmitted to the other mobile terminal 20 connected to the wireless communication network in operation S410. At this point, the service request information may be primarily transmitted to the management device 40, or may be transmitted to the technician mobile terminal 30 in addition to the manager mobile terminal 20 connected to communicate with the management device 40.

Additionally, when it is determined that the user information and/or warrantee information are/is not pre-stored in the memory 160 of the user mobile terminal 10 or the memory 44 of the management device 40 in operation S400, the control unit controls the display unit 151 to display the user information input window 280 or the warrantee information input window 290 in operation S420 or operation S450. However, when it is searched that only one of the user information and warrantee information is pre-stored in operation S400, only one of the user information input window 280 and the warrantee information input window 290 may be displayed in order to input the other one.

Hereinafter, the case that it is determined that all the user information and warrantee information are not pre-stored in operation S400 will be described. According to this embodiment, it is described that the user information input window 280 for inputting user information is displayed first in operation 420, and then, the warrantee information input window 290 for inputting warrantee information is displayed in operation 450. However, the present invention is not limited thereto, and thus, their displaying order may be inverse.

When the user information is inputted through the user information input window 280 in operation S430, the control unit 180 searches whether the warrantee information is pre-stored in operation S440. When the pre-stored warrantee information is not searched from the user mobile terminal 10 or the management device 40, the warrantee information input window 290 is displayed on the display unit 151 in operation S450. Then, when the warrantee information is inputted through the warrantee information input window in operation S460, the information inputted through the service request schedule input window 243 and also the service request information including the user information and warrantee information are transmitted via a wireless communication network in operation S410. Of course, when it is determined that there is at least one of user information and warrantee information pre-stored in the management device 40 in operation S400, only the updated information on the basis of information inputted from operation S430 or operation S460 may be transmitted excluding the pre-stored information.

After the service request information is transmitted in operation S410, a response on the service request is received via a wireless communication network in operation S470, and the control unit controls the display unit 151 in order to display a service reservation alarm window (not shown) notifying that a service request schedule is reserved in operation S480.

A user may confirm the result of processing a service request through the service reservation alarm window. The service reservation alarm window may include a service dispatch schedule displayed.

The service dispatch schedule does not always match a service request schedule that a user requests. The reason is that sometimes a user adjusts a desired service request schedule through the manager mobile terminal 20 in order to set up a service dispatch schedule, and notifies it.

The display unit 151 displays a confirmation menu for receiving an input on whether the contents displayed on the service reservation alarm window are confirmed. When the confirmation menu is selected and inputted through the user input unit 130 in operation S490, the control unit 180 controls the display unit 151 in order to display the service request list 265 in operation S500.

The service request list 265 may display service request items on already completed service requests, and also service request items currently in reservation (that is, which are received in operation S470 as completed service reservation through the transmission of the service request information in operation S410).

Moreover, when one of the service request items displayed on the service request list 265 is selected in operation S510, the control unit 180 may control the display unit 151 to display the service satisfaction input window 272 for inputting satisfaction ratings on the completed service request item in operation S520.

Then, when service satisfaction ratings on completed service request items are inputted from a user through the service satisfaction input window 272 in operation S530, the control unit 180 transmits the inputted satisfaction information via a wireless communication network, and transmits the service satisfaction ratings to the management device 40 or the other mobile terminals 20 and 30 connected to the wireless communication network in operation S540.

Hereinafter, referring to FIGS. 19 to 23, a UI provided through the manager mobile terminal 20 will be described. The UI is implemented by driving a specific application stored in the memory 160 of the manager mobile terminal 20. The application may be provided together with a mobile terminal, and may be downloaded by accessing an application web server on internet. Especially, the manager mobile terminal 20 should be understood as a sort of recording medium for storing application. This is the same when an application is downloaded via internet.

FIG. 19 is a screen view displayed through the display unit 151 of a manager mobile terminal according to an embodiment of the present invention. Hereinafter, the manager mobile terminal 20 follows the configuration of the mobile terminal 100 described with reference to FIGS. 5 to 7.

Referring to FIG. 19, once a specific application is driven through the manager mobile terminal 20, an initial screen 405 is displayed, and then, a main screen 410 including a service request notification list 412 is displayed through the display unit 151. The control unit 180 calls and drives an application stored in the memory 160, and controls the initial screen 405 and the main screen 410 to be sequentially displayed.

While the initial screen 405 is displayed, the control unit 180 may control the wireless communication unit 110 to attempt an access to a wireless communication network. Once the connection is made, the service request notification list 412 may be updated by receiving service request information from the management device 40, that is, service request information requested from the user mobile terminal 10.

Service request details requested through the user mobile terminals 10 are displayed by each item in the service request notification list 412. Each of service request notification items 412a, 412b, and 412c in the service request notification list 412 shown in FIG. 19 displays service request information requested from a first user User1, a second user User 2, and a third user User 3.

The service request information that a user transmits through the mobile terminal 10 via a wireless communication network may include information on an abnormal symptom of an electronic device to be serviced (refer to FIG. 10), a service request schedule (refer to FIG. 11(a) to FIG. 11(d)), additional information (refer to FIG. 11(e)), user information (refer to FIG. 15), and/or warrantee information (refer to FIG. 16).

The service request notification list 412 may display information based on the service request information. Referring to FIG. 19, a first service request notification item 412a may include service request information requested from the first user User 1. That is, through the first service request notification item 412a, we can tell that there is power failure on electricity supply due to an abnormal symptom of an electronic device that the first user User1 wants to receive a service and a service request schedule that the first user User1 wants is between 9:00 a.m. to 12:00 p.m. on October 10, 2011.

The information obtained from the second service request notification item 412b requested from the second user User 2 and the third service request notification item 412c requested from the third user User 3 will not be described because this can be fully understood with reference to the above-mentioned description about the first service request notification item 412a and the contents shown in FIG. 19.

Moreover, when the list update menu 411 of the main screen 410 is selected, the control unit 180 transmits to the management device 40 a retransmission request signal for requesting the retransmission of service request information through the wireless communication unit 110. When the service request information is received from the management device 40 to the wireless communication unit 110 in response to the retransmission request signal, based on this, the service request notification list 412 is updated and displayed.

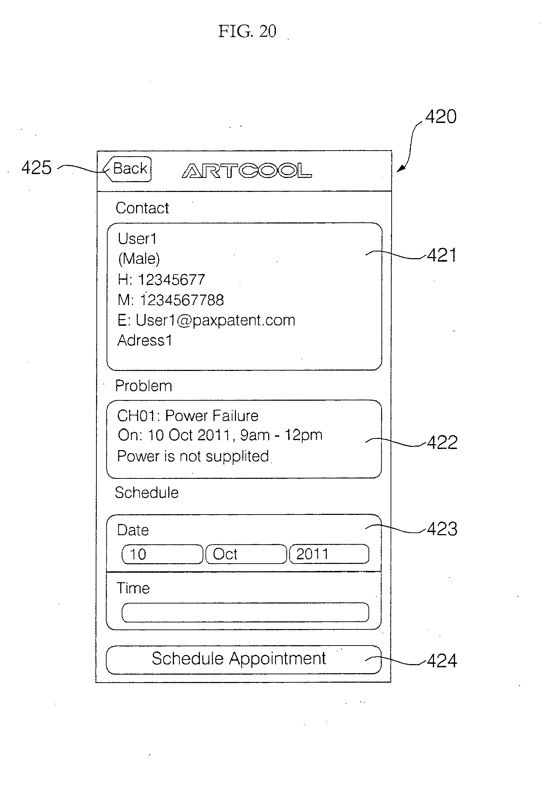

FIG. 20 is view illustrating a screen 420 displayed through the display unit 151 of the manager mobile terminal 20 when the first service request notification item 412a is selected from the service request notification list 412 of FIG. 19.

Once one item is selected from the service request notification list 412, the service request information display screen 420 for displaying specific service request information on the selected service request notification item is displayed through the display unit 151.

In FIG. 20, the service request information display screen 420 is displayed when the first service request notification item 412a is selected in FIG. 19. The service request information display screen 420 displays first user information, information on an abnormal symptom of an electronic device to be serviced, information on a service request schedule, additional information and/or information on a service dispatch schedule inputted from a manager.

According to this embodiment, the service request information display screen 420 includes a user information display window 421 displayed based on user information transmitted from the a first user mobile terminal 11 via a wireless communication network, a service request schedule display window 422 for displaying information on an abnormal symptom of a service target electronic device in addition to the service request schedule transmitted from the first user mobile terminal 11 via the wireless communication network, and a service dispatch schedule input window 423 for receiving the service dispatch schedule from the manager, but the present invention is not limited thereto.

As described in relation to the configuration and operation of the user mobile terminal, the contents displayed through the service request information display screen 420 is based on information transmitted to the manager mobile terminal via a wireless communication network after being inputted through the user mobile terminal.

The manager confirms the service request schedule through the service request schedule display window 422, and if necessary, may input the adjusted service request schedule (i.e. the service dispatch schedule) through the service dispatch schedule input window 423.

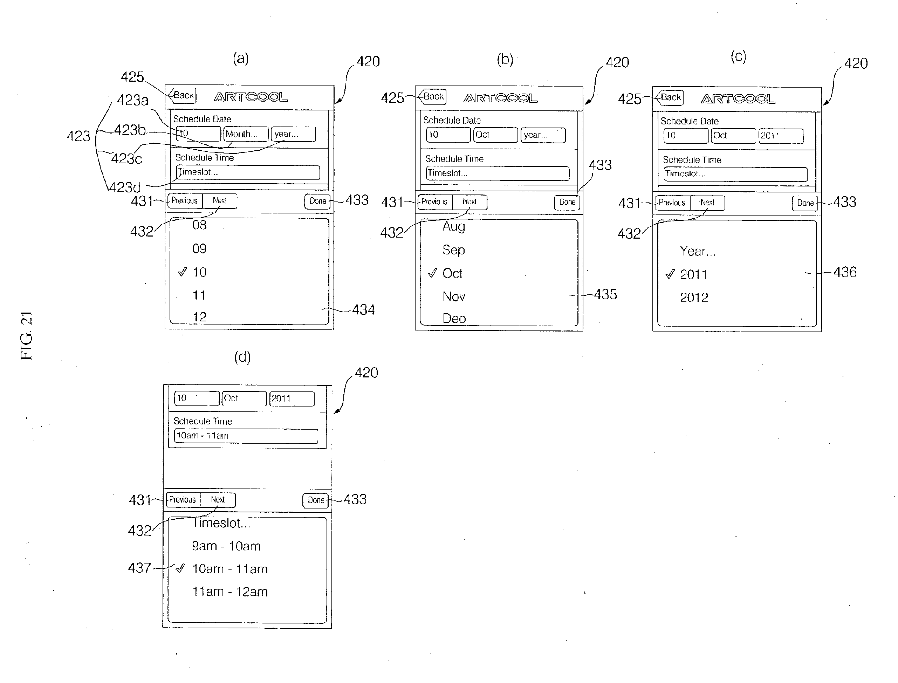

In FIGS. 21(a) to 21(d), processes for inputting a technician dispatch schedule by the manager through the service dispatch schedule input window 423 are sequentially illustrated. Hereinafter, the service dispatch schedule input window 423 includes input windows 423a, 423b, 423c, and 423d for inputting each of day, month, year, and time, but the present invention is not limited thereto. For example, it is apparent that a key pad is used to input a text by a user's push or touch operation.

When a day input window 423a, a month input window 423b, a year input window 423c, and a time input window 423d are selected, each of a day selection input window 434, a month selection input window 435, a year selection input window 436, and a time selection input window 437 is displayed. Then, when a day, a month, a year, and a time are selected through the selection input windows 434, 435, 436, and 437, their result are respectively reflected on the day input window 423a, the month input window 423b, the year input window 423c, and the time input window 423d. However, in terms of operating convenience, inputting a day, a month, a year, and a time sequentially by manipulating the back to previous step menu 431, the forward to next step menu 432, and the input confirmation menu 433 is better than inputting a technician dispatch schedule by selecting each of the input windows or selection input windows.

In more detail, as shown in FIG. 21(a), after a day is selected through the day selection input window 434 and then the forward to next step menu 432 is selected, as shown in FIG. 21(b), the month selection input window 435 is displayed. After a month is selected through the month selection input window 435 and then the forward to next step menu 432 is selected, as shown in FIG. 21(c), the year selection input window 436 is displayed. After a year is selected through the year selection input window 436 and then the forward to next step menu 432 is selected, as shown in FIG. 21(d), the time selection input window 437 is displayed.

A process for inputting day/month/year/time through the day selection input window 434, the month selection input window 435, the year selection input window 436, and the time selection input window 437 is almost similar to that described with reference to FIG. 11. However, there is a difference that a time slot selectable through the time selection input window 437 is more divided than that selectable through the user mobile terminal 10. For example, compared to FIG. 11(d), when a time slot is inputted through a user mobile terminal, a 3hr unit input is possible, but when being inputted through a manager mobile terminal, a 1hr unit input is possible.

When a manager completes all schedule input through the service dispatch schedule input window 423 and then selects the service dispatch request transmission menu 424 in order to input a value, the control unit 180 controls the wireless communication unit in order to service dispatch request information including information inputted through the service dispatch schedule input window 423 via wireless communication network. Then, the service dispatch request information is transmitted to the technician mobile terminals 31 and 32 connected to the wireless communication network. At this point, the service dispatch request information may be transmitted to the management device 40, or may be transmitted to the technician mobile terminals 31 and 32 through the management device 40.

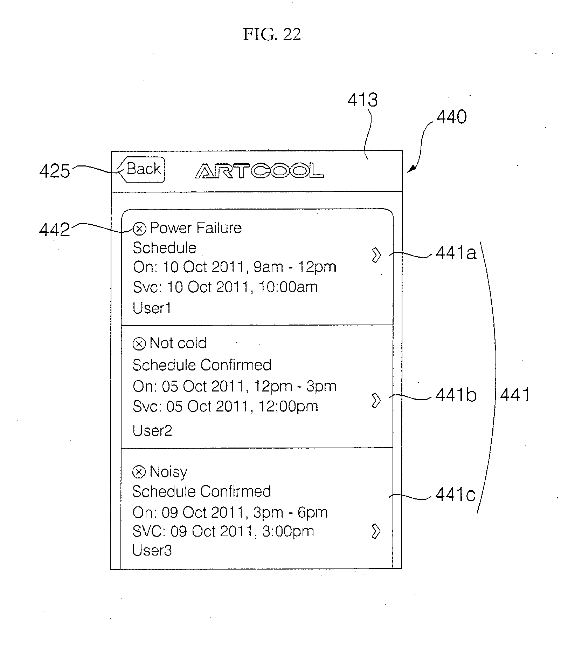

FIG. 22 is a view of a screen 440 including the service dispatch request list 441, which is displayed through the display unit 151 of the manager mobile terminal 20.

Referring to FIG. 22, when the service dispatch request list display menu 413 displayed through the main screen 410 is selected or the service dispatch request transmission menu 424 is selected after the schedule input is completed through the service dispatch schedule input window 423, the screen 440 including a list of completed service dispatch requests, that is, the service dispatch request list 441, is displayed through the display unit 151.

The service dispatch request list 441 may display service dispatch request items 441a, 441b, and 441c that notification to the technician mobile terminal 30 is completed. Each service dispatch request item may display information on an abnormal symptom of an electronic device on a corresponding service dispatch request item, a service request processing state, a service request schedule, a service dispatch schedule, user information, and/or warrantee information. For example, the first service dispatch request item 441a displays service request information requested from a first user User 1. From this, we can tell that power supply abnormal symptom ('Power Failure') occurs in an electronic device of the first user User 1; there is no acceptance response from a technician mobile terminal ('Schedule') after a service dispatch schedule is notified to the technician mobile terminal; the service request schedule from the first user User 1 is between 9:00 a.m. to 12:00 p.m. on October 10, 2011 ('On: 10 Oct 2011, 9am-12pm'); and the service dispatch schedule adjusted by the manager is 10:00 a.m. on October 10, 2011 ('Svc: 10 Oct 2011, 10:00am').

Information from the second service dispatch request item 441b and the third service dispatch request item 441c may be obtained with reference to the description for the first service dispatch request item 441a and the contents shown in FIG. 22, and thus, its detailed description will be omitted. However, the second service dispatch request item 441b and the third service dispatch request item 441c displays that there is an acceptance response ('Schedule Confirmed') to the service dispatch request that the manager notifies to technicians, from someone.

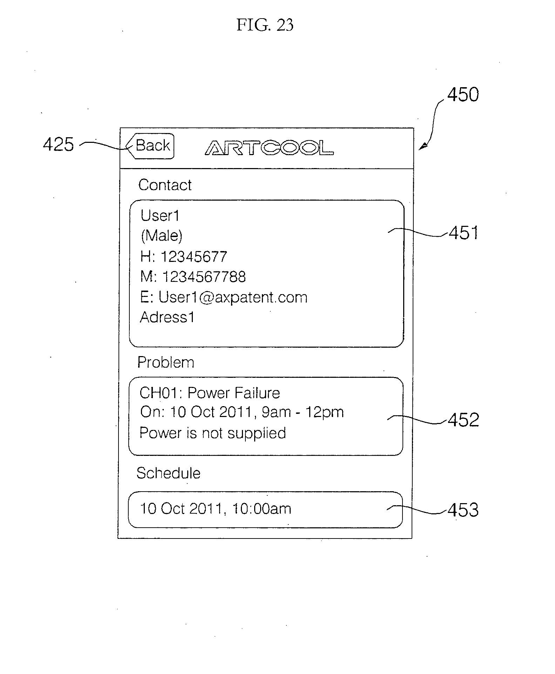

FIG. 23 is view illustrating a screen displayed through the display unit 151 of the manager mobile terminal 20 when the first service request item 441a is selected.

Once one item is selected from the service dispatch list 441, the service dispatch request information display screen 450 for displaying specific details on the selected service dispatch request item is displayed through the display unit 151. Referring to FIG. 23, the service dispatch request information display screen 450 may display user information, warrantee information, information on an abnormal symptom of an electronic device, a service request schedule, a service dispatch schedule and/or additional information.

According to this embodiment, the service dispatch request information display screen 450 includes a user information display window 451 displayed based on user information transmitted from the a first user mobile terminal 11 via a wireless communication network, a service request schedule display window 452 for displaying information on an abnormal symptom of a service target electronic device in addition to the service request schedule transmitted from the first user mobile terminal 11 via the wireless communication network, and a service dispatch schedule display window 453 for displaying a service dispatch schedule inputted by the manager through the service dispatch schedule input window 423, but the present invention is not limited thereto.

As described in relation to the configuration and operation of the user mobile terminal, the contents displayed through the service dispatch request information display screen 450 is based on information transmitted to the manager mobile terminal via a wireless communication network after being inputted through the user mobile terminal.

The reference number 425 refers to a back to previous step menu that receives a selection on returning to a previous step

Additionally, as shown in FIG. 19, the first service request notification item and the first service request notification item display service requests that a service dispatch schedule is not adjusted by the manger yet ('New'), and the third service request notification item 412c displays a case that all technicians reject the notified service dispatch schedule after the service dispatch schedule is adjusted by the manager and is notified to technician mobile terminals ("Schedule Rejected').

When the service dispatch request item that a rejection response to the service dispatch request is notified from technicians, that is, the third service dispatch request item 412c is selected, the service request information display screen 420 of FIG. 21 is displayed through the display unit 151. The manager may adjust and input the service dispatch schedule again through the service dispatch schedule input window 423, and then may retransmit the service dispatch request to the technician mobile terminals 31 and 32 according to the adjusted service dispatch schedule.

Moreover, an item that a service dispatch schedule is inputted completely among service request notification items selected on the service request notification list 412 (that is, an item that a service dispatch schedule is inputted through the service dispatch schedule input window 423 and a service dispatch request is transmitted) may be deleted from the service request notification list 412, and may be displayed through the service dispatch request list 441. For example, the first service request notification item 412a of FIG. 19 is illustrated as new. When the first service request item is selected by a manager, and a service dispatch schedule is inputted and transmitted via wireless communication network, the first service request notification item 412a is deleted from the service request notification list 412, and the first service dispatch request item 441a corresponding to the first service request notification item 412a is displayed through the service dispatch request list 441 of FIG. 22.

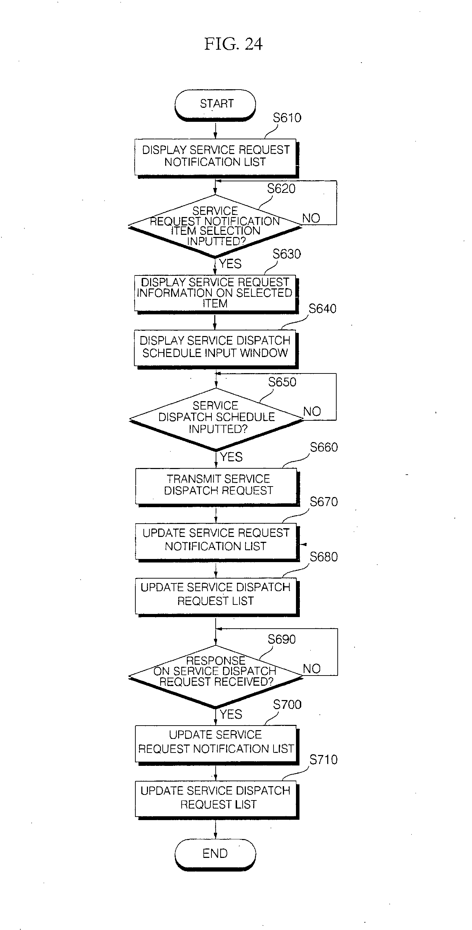

FIG. 24 is a flowchart illustrating a method of operating the manager mobile terminal 20 according to an embodiment of the present invention.

Referring to FIG. 24, the method of operating a manager mobile terminal includes: receiving service request information on an electronic device via a wireless communication network; displaying the received service request information through a display unit; displaying a service dispatch schedule input window for receiving a technician dispatch schedule on the service request information displayed on the display unit; receiving the service dispatch schedule through the service dispatch schedule input window, and transmitting the service dispatch schedule received through the service dispatch schedule input window to the technician mobile terminal 30 connected to the wireless communication network.

Once a specific application is driven through the manager mobile terminal 20, a service request notification list 412 is displayed through the display unit 151 in operation S610. The service request notification list 412 includes service request items based on the service request information received through the wireless communication unit 110.

The service request information received through the wireless communication unit 110 may include a service request schedule transmitted from the user mobile terminals 10 via a wireless communication network, information on an abnormal symptom of a service target electronic device, user information, and/or warrantee information.

When the service request notification item is selected from the service request notification list 412 in operation S620, the control unit 180 controls the display unit 151 to display service request information as specific information on the selected service request item in operation S630. Additionally, the display unit 151 may display the service dispatch schedule input window 423 for receiving a service dispatch schedule on the selected service request item in operation S640.

When a service dispatch schedule is inputted through the service dispatch schedule input window 423 in operation S650, the service dispatch request is transmitted to the technician mobile terminals 31 and 32 via a wireless communication network according to the inputted service dispatch schedule in operation S660.

Once the service dispatch request transmission is completed in operation S660, the control unit 180 updates the service request notification list 412 displayed on the display unit 151 in operation S670. At this point, a service request notification item that the service dispatch request transmission is completed may be deleted from the service request notification list 412 and is displayed through the service dispatch request list 440 instead of that in operation S680.

Moreover, when a response to the service request is received from the technician mobile terminal 30 through the wireless communication unit 110, the control unit 180 may update the service request notification list in response to the received response in operation S700, or may update the service dispatch request list 441 in operation S710.

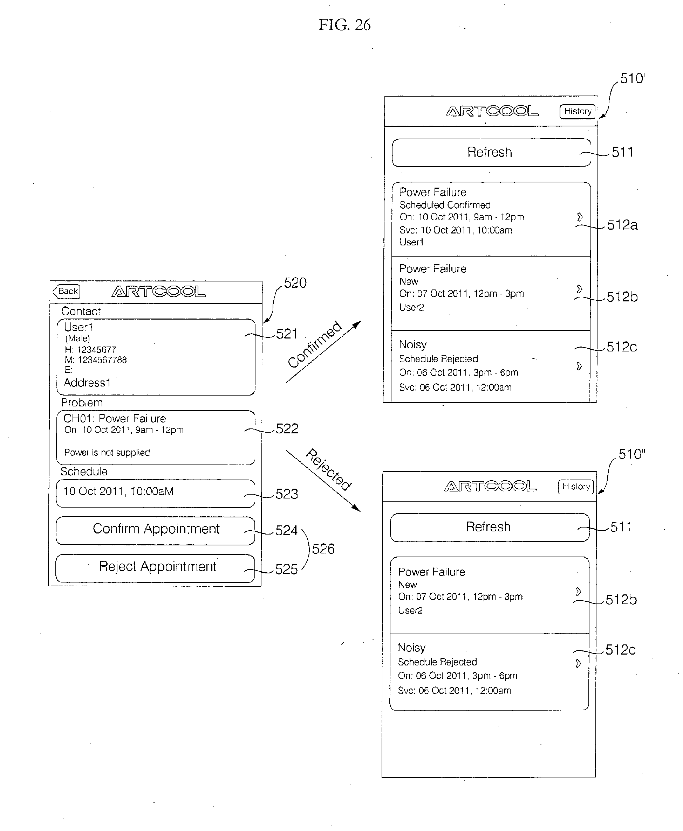

FIG. 25 is a screen view displayed through the display unit of the technician mobile terminal 30 according to an embodiment of the present invention. FIG. 26 is a view when the screen 510' that a technician confirms a service display request through the screen displayed through the display unit 151 of the technician mobile terminal 30 when the service dispatch request item of FIG. 25 is selected is compared with the screen 510" displayed when the technician rejects the service dispatch request.

Hereinafter, referring to FIGS. 25 to 26, a UI provided through the technician mobile terminal 30 will be described. The UI is implemented by driving a specific application stored in the memory 160 of the technician mobile terminal 30. The application may be provided together with a mobile terminal, and may be downloaded by accessing an application web server on internet. Especially, the technician mobile terminal 30 should be understood as a sort of recording medium for storing application. This is the same when an application is downloaded via internet.

Hereinafter, the technician mobile terminal 30 follows the configuration of the mobile terminal 100 described with reference to FIGS. 5 to 7.

Referring to FIG. 25, once a specific application is driven through the technician mobile terminal 30, an initial screen 505 is displayed, and then, a main screen 510 including a service dispatch request notification list 512 is displayed through the display unit 151. The control unit 180 calls and drives an application stored in the memory 160, and controls the initial screen 505 and the main screen 510 to be sequentially displayed.

While the initial screen 505 is displayed, the control unit 180 may control the wireless communication unit 110 to attempt an access to a wireless communication network. Once the connection is made, the service dispatch request notification list 512 may be updated by receiving service dispatch request information. The service dispatch request information includes information on a service dispatch schedule for providing a service to an electronic device' user. For example, as described with reference to FIG. 21, when there is a service request from a user, a manager may adjust a service dispatch schedule through the manager mobile terminal 20.

The service dispatch request notification list 512 includes service dispatch request notification items that classifies service dispatch requests received through the wireless communication unit 110, and confirms information on a user (who requests a service through the service dispatch request notification item) and also a service dispatch schedule.

In more detail, the service dispatch request notification list 512 of FIG. 25 includes a. first service dispatch request notification item 512a, a second service dispatch request notification item 512b, and a third dispatch request notification item 513c.

The first service dispatch request notification item 512a displays the event that there is a service request on dispatching a technician between 9:00 a.m. and 12:00 p.m. on October 10, 2011 from a first user User 1 due to a power supply abnormal symptom ('Power Failure') of an electronic device, the event that a service dispatch schedule on requesting a technician dispatch, which is adjusted by a manager in response to the service request, is 10:00 a.m. on October 10, 2011 ('Svc: 10 Oct 2011, 10:00am'), and the event that a technician does not provide a response to the service dispatch schedule yet('New').

The second service dispatch request notification item 512b displays the event that there is a service request on dispatching a technician between 12:00 p.m. and 3:00 p.m. on October 7, 2011 from a second user User 2 due to a power supply abnormal symptom of an electronic device, and the event that there is no response to whether to accept the service request ('NEW').

The third service dispatch request notification item 512c displays the event that there is a service request on dispatching a technician between 3:00 p.m. and 6:00 p.m. on October 6, 2011 from a third user User 3 due to an abnormal noise symptom ('Noisy') of an electronic device, the event that a service dispatch schedule on requesting a technician dispatch, which is adjusted by a manager in response to the service request, is 3:00 p.m. on October 6, 2011, and the event that the technician rejects the technician dispatch schedule ('Schedule Rejected').

Moreover, when the list update menu 511 of the main screen 510 is selected, the control unit 180 transmits to the management device 40 a retransmission request signal for requesting the retransmission of service dispatch request information through the wireless communication unit 110. When the service dispatch request information is received from the management device 40 to the wireless communication unit 110 in response to the retransmission request signal, based on this, the service dispatch request notification list 512 is updated and displayed.

When a predetermined service request notification item is selected from the service dispatch request notification list 512, the control unit 180 controls the display unit 151 to display the screen for displaying service dispatch request information corresponding to the selected service request notification item, that is, the service dispatch request information display screen 520.

The service dispatch request information displayed through the service dispatch request information display screen 520 may include user information, information on abnormal symptom of an electronic device, information on a service request schedule, and/or information on a service dispatch schedule.

According to this embodiment, the service dispatch request information display screen 520 includes a user information display window 521 displayed based on user information transmitted from the a first user mobile terminal via a wireless communication network, a service request schedule display window 522 for displaying information on an abnormal symptom of a service target electronic device in addition to the service request schedule transmitted from the first user mobile terminal via the wireless communication network, and a service dispatch schedule display window 523 for displaying a service dispatch schedule inputted from the manager mobile terminal 20 via the wireless communication network, but the present invention is not limited thereto.

Additionally, the service dispatch request response input window 526 may be displayed through the display unit 151. The service dispatch request response input window 526 is to receive an input on whether to accept a service dispatch request. A technician confirms the service dispatch request information through the service dispatch request response input window 526 and inputs whether to accept a corresponding service dispatch request. The service dispatch request response menu 526 may include an acceptance response input menu 524 and a rejection response input menu 525.

When the acceptance response input menu 524 is selected, a service dispatch request notification list is displayed as shown on the screen 510' of FIG. 26. Compared to FIG. 25, the first service dispatch request notification item 512a is changed into acceptance and displayed ('Schedule Confirmed').

Additionally, when the rejection response input menu 525 is selected, a service dispatch request notification list is displayed as shown on the screen 510" of FIG. 26. Compared to FIG. 25, the first service dispatch request notification item 512a is deleted.

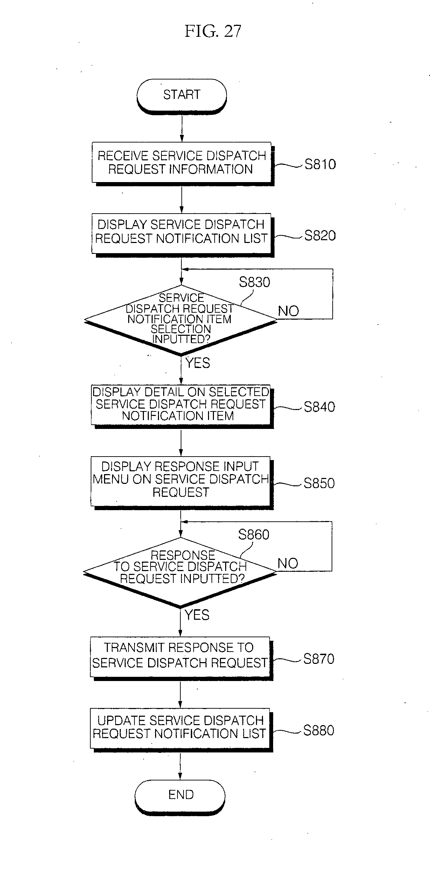

FIG. 27 is a flowchart illustrating a method of operating a technician mobile terminal according to an embodiment of the present invention.

Referring to FIG. 27, the method of operating the technician mobile terminal 30 includes: receiving a service dispatch request through a wireless communication network; displaying the service dispatch request notification list 512 including the items of the received service dispatch requests through the display unit 151; selecting one service dispatch request notification item from the service dispatch request notification list 512; displaying service dispatch request information on the selected service dispatch request notification item through the display unit 151; displaying the service dispatch response input menu 526 to receive a response to the selected service dispatch request notification item through the display unit 151; and notifying whether to accept the service dispatch request to the other mobile terminal via a wireless communication network according to the result inputted through the service dispatch request response input menu 526.

In more detail, when service dispatch request information including a service dispatch schedule is received from the other mobile terminal connected to the wireless communication network, for example, the manager mobile terminal 20 in operation S810, according thereto, the control unit 180 displays the service dispatch request notification list 512 through the display unit 151 in operation S820. Accordingly, as confirming the service dispatch request notification list displayed on the technician mobile terminal 30, a technician may confirm that there is a service request on an electronic device from a user.

Here, the service dispatch information includes user information, warrantee information, information on an abnormal symptom of an electronic device, information on a service request schedule from a user, and/or information on a service dispatch schedule from a manager. Additionally, this information may be displayed through the service dispatch request notification list as mentioned above.

When one time is selected from the service dispatch request notification list 512 in operation S830, the control unit 180 controls the display unit 151 to display a detail on the selected service dispatch request notification item in operation S840. That is, the display unit 151 displays user information, warrantee information, information on an abnormal symptom of an electronic device, information on a service request schedule from a user, and/or information on a service dispatch schedule from a manager in operation S840.

Additionally, the service dispatch request response input window 526 may be displayed through the display unit 151. When a technician confirms information displayed in operation S840 and, according thereto, inputs whether to accept the service dispatch request through the service dispatch request response input menu 526 in operation S860, the control unit 180 may control the wireless communication unit 110 to transmit a response result on the service dispatch request in operation S870. The respond result to the service dispatch request may be transmitted to the management device 40 connected to the wireless communication network or another mobile terminal, for example, the manager mobile terminal 20 or the user mobile terminal 10.

Moreover, in operation S880, the control unit 180 may update the service dispatch request notification list 512 in operation S860, and this process was described with reference to FIG. 26.

A mobile terminal and a method of operating the same according to the present invention provide prompt response service.

Additionally, in relation to a mobile terminal and a method of operating the same according to the present invention, when a service request schedule that a user selects is notified to another mobile terminal, a manager or technician confirms the service request schedule through a manager or technician mobile terminal, and in consideration of that, adjusts a service dispatch schedule. Therefore, a schedule that a user requests will be reflected as much as possible and also the efficient management of a service providing resource is possible, so that prompt and seamless service is provided in response to a user's service request.

The invention can also be embodied as computer readable codes on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, optical data storage devices, and carrier waves (such as data transmission through the Internet). The computer readable recording medium can also be distributed over network coupled computer systems so that the computer readable code is stored and executed in a distributed fashion.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A method of operating a mobile terminal (10), the method comprising:
displaying (S310) a service request menu (222) through a display unit (151);
receiving (S320) a selection input of the service request menu (222);
displaying (S360) a service request schedule input window (243) through the display unit (151) when the service request menu (222) is selected and inputted;
receiving (S370) an input of a service request schedule through the service request schedule input window (243); and
transmitting (S410) service request information, which includes the service request schedule inputted through the service request schedule input window (243), to another mobile terminal (20) connected via a wireless communication network.

2. The method of claim 1, further comprising displaying (S380) a service request transmission menu (249) through the display unit (151), wherein when the service request transmission is selected and inputted, the service request information is transmitted to another mobile terminal (20) connected via a wireless communication network.

3. The method of claim 1 or 2, wherein the service request schedule input window (243) is divided into a day input window, a month input window, and a time input window and is displayed in order to receive the service request schedule by a day, a month, and a time.

4. The method of claim 3, wherein when one of the day input window, the month input window, and the time input window is selected, a day selection input window, a month selection input window, and a time input selection window are displayed, where a desired day, month, or time slot is selected and inputted through a predetermined list that divides a day, a month, and a time by a day unit, a month unit, and a time slot unit, respectively, according to the selected input window.

5. The method of claim 4, wherein when one of the day selection input window, the month selection input window, and the time input selection window is selected, once a day, a month, or a time slot is selected and inputted through the selected selection input window, a selection input window having no input is displayed among the day selection input window, the month selection input window, and the time input selection window.

6. The method of any one of claims 1 to 5, further comprising displaying (S330) an abnormal symptom list that divides and displays abnormal symptoms of an electronic device by each item, through the display unit (151).

7. The method of claim 6, further comprising, when one of items in the abnormal symptom list is selected, displaying (S350) action information on the selected item through the display unit (151).

8. The method of claim 7, wherein the action information and the service request schedule input window (243) are displayed on the same screen and the action information is displayed above the service request schedule input window (243), and/or
wherein the displaying (S350) of the action information comprises displaying an action that a user can take according to an abnormal symptom of an electronic device through at least one of an image or a video, and/or
further comprising receiving update information on the action information through a wireless communication network, wherein the action information displayed through the display unit is based on the update information.

9. The method of claim 1, further comprising:
displaying a service request list display menu (223) through the display unit (151); and
when the service request list display menu (223) is selected, displaying a service request list, where service requests that the transmission of the service request schedule information is completed are divided by each item, through the display unit (151).

10. The method of claim 9, further comprising:
selecting a service request item that the transmission of the service request information is completed from the service request list; and
when the service request item is selected, displaying (S520) a service satisfaction input window for receiving a service satisfaction on the selected service request item through the display unit (151).

11. The method of claim 10, when a service satisfaction is inputted through the service satisfaction input window, further comprising transmitting (S540) the inputted service satisfaction to another portable via a wireless communication network, and/or
wherein when the service satisfaction input window is selected, ratings selectable through the display unit are divided and displayed and a satisfaction selection input window for receiving a selection input on one of the ratings is displayed, and/or
further comprising displaying an additional information input window for receiving a predetermined text, in addition to the service satisfaction input window.

12. The method of any one of claims 1 to 11, further comprising:
displaying (S420) a user information input menu (280) through the display unit (151); and
when the user information input menu is selected, displaying a user information input window for receiving user information through the display unit (151).

13. The method of claim 12, wherein the user information input window (280) comprises at least one of a user name input window, a user gender input window, a user address input window, a user postal code input window, and a user contact input window.

14. The method of claim 13, further comprising transmitting information inputted through the user information input window (280) to another terminal via a wireless communication network, and/or
wherein the service request information transmission via the wireless communication network is based on the condition that user information input is made previously through the user information input window.

15. The method of any one of claims 1 to 14, further comprising:
displaying (S450) a warrantee information input menu through the display unit (151); and
when the warrantee information input menu is selected, displaying a warrantee information input window for receiving warrantee information through the display unit (151).

16. The method of claim 15, wherein the warrantee information input window comprises at least one of an electronic device purchase date input window, an electronic device identification information input window, and a supplier information input window, and/or
further comprising transmitting information inputted through the warrantee information input window to another terminal through a wireless communication network, and/or
wherein the service request information transmission via the wireless communication network is based on the condition that warrantee information input is made through the warrantee information input window.

17. The method of any one of claims 1 to 16, further comprising:
receiving (S470) a response to a service request via a wireless communication network; and
displaying (S480) an alarm window for notifying that a service request is reserved through the display unit (151).

18. The method of claim 17, wherein the alarm window displays a schedule that a technician is dispatched to provide a service.

19. A mobile terminal (10) comprising:
a display unit (151) configured to display a service request menu (222);
a wireless communication unit connected to be communicated with another mobile terminal (20) connected to a wireless communication network; and
a control unit (180) configured to control the display unit (151) to display a service request schedule input window (243) when the service request menu is selected, and to control the wireless communication unit to transmit service request information, which includes a service request schedule inputted through the service request schedule input window (243), to another mobile terminal (20).

20. The mobile terminal of claim 19, wherein the control unit (180) is further configured to display a service request transmission menu (249) through the display unit (151), and transmits the service request information through the wireless communication unit when the service request transmission menu is selected.

21. The mobile terminal of claim 19, wherein the service request schedule input window (243) is divided into a day input window, a month input window, and a time input window and is displayed in order to receive the service request schedule by a day, a month, and a time,
wherein preferably when one of the day input window, the month input window, and the time input window is selected, the control unit displays a day selection input window, a month selection input window, and a time input selection window through the display unit, (151) where a desired day, month, or time slot is selected and inputted through a predetermined list that divides a day, a month, and a time by a day unit, a month unit, and a time slot unit, respectively, according to the selected input window, and
wherein further preferably when one of the day selection input window, the month selection input window, and the time input selection window is selected, once a day, a month, or a time slot is selected and inputted through the selected selection input window, a selection input window having no input is displayed among the day selection input window, the month selection input window, and the time input selection window.

22. The mobile terminal of claim 19, wherein the control unit (180) is configured to display an abnormal symptom list that divides and displays abnormal symptoms of an electronic device by each item, through the display unit (151).

23. The mobile terminal of claim 22, wherein when one of items in the abnormal symptom list is selected, the control unit (180) is configured to display action information on the selected item through the display unit (151).

24. The mobile terminal of claim 23, wherein (180) is configured to display the action information and the service request schedule input window (243) on the same screen and the action information is displayed above the service request schedule input window (243), and/or
wherein the action information is displayed by displaying an action that a user can take according to an abnormal symptom of an electronic device through at least one of an image or a video, and/or
wherein the wireless communication unit is configured to receive update information on the action information through a wireless communication network, and
the action information displayed through the display unit (151) is based on the update information.

25. The mobile terminal of claim 19, wherein the control unit (180) is configured to display a service request list display menu through the display unit (151); and when the service request list display menu is selected, to display a service request list, where service requests that the transmission of the service request schedule information is completed are divided by each item, through the display unit (151).

26. The mobile terminal of claim 25, wherein when a service request item that the transmission of the service request information is completed is selected from the service request list, the control unit (180) is configured to display a service satisfaction input window for receiving a service satisfaction on the selected service request item through the display unit (151).

27. The mobile terminal of claim 26, wherein when a service satisfaction is inputted through the service satisfaction input window, the control unit (180) is configured to control the wireless communication unit to transmit the inputted service satisfaction to another portable, and/or
wherein when the service satisfaction input window is selected, the control unit (180) is configured to divide and displays ratings selectable through the display unit (151) and to display a satisfaction selection input window for receiving a selection input on one of the ratings, and/or
wherein the control unit (180) is further configured to display an additional information input window for receiving a predetermined text, in addition to the service satisfaction input window.

28. The mobile terminal of claim 19, wherein the control unit (180) is configured to display a user information input menu through the display unit (151), and when the user information input menu is selected, to display a user information input window for receiving user information through the display unit (151).

29. The mobile terminal of claim 28, wherein the user information input window comprises at least one of a user name input window, a user gender input window, a user address input window, a user postal code input window, and a user contact input window, and/or
wherein the control unit (180) is configured to control the wireless communication unit to transmit information inputted through the user information input window to another terminal, and/or
wherein the service request information transmission via the wireless communication network is based on the condition that user information input is made previously through the user information input window.

30. The mobile terminal of claim 19, wherein the control unit (180) is configured to display a warrantee information input menu through the display unit (151); and when the warrantee information input menu is selected, to display a warrantee information input window for receiving warrantee information through the display unit (151).

31. The mobile terminal of claim 30, wherein the warrantee information input window comprises at least one of an electronic device purchase date input window, an electronic device identification information input window, and a supplier information input window, and/or
wherein the control unit (180) is configured to transmit information inputted through the warrantee information input window to another terminal through a wireless communication network, and/or
wherein the service request information transmission via the wireless communication network is based on the condition that warrantee information input is made through the warrantee information input window.

32. The mobile terminal of claim 19, wherein the control unit (180) is configured to display at least one of a service request list display menu, a user information input menu, and a correction information input menu in addition to the service request menu through the display unit (151).

33. The mobile terminal of claim 32, where menus displayed through the display unit (151) are arranged horizontally at the bottom of the screen displayed on the display unit.

34. The mobile terminal of claim 19, wherein the wireless communication unit is configured to receive a response to a service request via a wireless communication network; and
the control unit (180) is configured to display an alarm window for notifying that a service request is reserved through the display unit (151).

35. The mobile terminal of claim 34, wherein the alarm window displays a schedule that a technician is dispatched to provide a service.
